(19) 

**Europäisches Patentamt**
**European Patent Office**
**Office européen des brevets**

(11) **EP 4 489 284 A1**

(12) **EUROPEAN PATENT APPLICATION**
published in accordance with Art. 153(4) EPC

(43) Date of publication:
**08.01.2025 Bulletin 2025/02**

(21) Application number: **23827344.5**

(22) Date of filing: **14.04.2023**

(51) International Patent Classification (IPC):
**H02M 1/42** *(2007.01)*    **H02M 1/32** *(2007.01)*
**H02H 7/12** *(2006.01)*    **H02H 3/44** *(2006.01)*

(52) Cooperative Patent Classification (CPC):
**H02H 3/44; H02H 7/12; H02M 1/32; H02M 1/42**

(86) International application number:
**PCT/KR2023/005080**

(87) International publication number:
**WO 2023/249224 (28.12.2023 Gazette 2023/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.06.2022 KR 20220077809**

(71) Applicant: **Samsung Electronics Co., Ltd
Suwon-si, Gyeonggi-do 16677 (KR)**

(72) Inventors:
• **BAN, Jieun**
  **Suwon-si, Gyeonggi-do 16677 (KR)**
• **LEE, Junghyun**
  **Suwon-si, Gyeonggi-do 16677 (KR)**
• **PARK, Youngjae**
  **Suwon-si, Gyeonggi-do 16677 (KR)**
• **CHO, Jehyung**
  **Suwon-si, Gyeonggi-do 16677 (KR)**
• **LEE, Teaho**
  **Suwon-si, Gyeonggi-do 16677 (KR)**

(74) Representative: **Walaski, Jan Filip et al
Venner Shipley LLP
200 Aldersgate
London EC1A 4HD (GB)**

(54) **ELECTRICAL DEVICE ACTIVELY OPERATING AT MULTIPLE INPUT VOLTAGES AND METHOD FOR CONTROLLING SAME**

(57)    An electrical device according to an embodiment of the disclosure controls an operation of a power factor correction circuit by setting an overvoltage protection level, an undervoltage protection level, and an input current limit level of the power factor correction circuit according to whether an input voltage of the power factor correction circuit is a low voltage or a high voltage, thereby preventing damage to components included in the electrical device and improving the performance of a load.

FIG. 3

**EP 4 489 284 A1**

## Description

Technical Field

An embodiment of the disclosure relates to an electrical device for actively operating at multiple input voltages (or a plurality of input voltages) by using a power factor correction (PFC) circuit, and a method for controlling same.

Background Art

Electrical devices operate as a power source is applied. The power source of electrical devices uses different input voltages by countries and regions. For example, in Korea, Vietnam, and Europe, the power source of electrical devices uses a high voltage. The high voltage may be, for example, 220 $V_{ac} \pm 10\%$. In Japan, the United States, Canada, and Taiwan, the power source of electrical devices uses a low voltage. The low voltage may be, for example, 110 $V_{ac} \pm 10\%$. In Brazil, the power source of electrical devices uses either a high voltage or a low voltage.

Therefore, electrical devices should be manufactured in consideration of the input voltage of a region where they will be used, and users need to use transformers as necessary.

To improve this, an electrical device that uses a voltage multiplier or a power factor correction circuit capable of using both a high voltage and a low voltage as input voltages has been proposed.

However, an electrical device using a voltage multiplier requires an additional circuit design without improving the power factor, which increases the cost of the device. An electrical device using a power factor correction circuit can improve the power factor while using alternating current input power sources of both a low voltage and a high voltage. However, because the variation range of the input power sources is significantly great compared to that of a single input power source, the margins of elements used in the electrical device should be selected to sufficiently great values. Due to this, the size of the electrical device increases and the price rises.

In addition, because the power factor correction circuit can set only one voltage and one current protection level for protecting the internal elements, elements such as fuses, relays, or/and bridge diodes, included in the electrical device are damaged when inrush current is generated while the electrical device operates, in a poor power supply region.

In addition, in order to use, at a low input voltage, the same power as at a high input voltage, the magnitude of input current increases, which increases the conduction loss of the electrical device and relatively lowers the operating efficiency of the electrical device.

Disclosure

Technical Solution

An electrical device according to an embodiment of the disclosure may include a power factor correction circuit configured to correct a power factor of the electrical device. The electrical device may include a first voltage sensor configured to detect input voltage information of the power factor correction circuit. The electrical device may include a second voltage sensor configured to detect DC link voltage information of the power factor correction circuit. The electrical device may include at least one processor.

The at least one processor according to an embodiment of the disclosure may be configured to obtain input voltage information of the electrical device based on the input voltage information detected by the first voltage sensor and the DC link voltage information detected by the second voltage sensor. The at least one processor according to an embodiment of the disclosure may be configured to compare the obtained input voltage information with preset reference voltage information so as to determine whether an input voltage of the electrical device is a low voltage or a high voltage. The at least one processor may be configured to set a protection level of the power factor correction circuit according to the determined input voltage. The at least one processor may be configured to control an operating cycle of a switch included in the power factor correction circuit based on the set protection level.

A method of controlling an electrical device including a power factor correction circuit according to an embodiment of the disclosure may include detecting input voltage information of the power factor correction circuit by at least one processor of the electrical device.

The method of controlling the electrical device including the power factor correction circuit according to an embodiment of the disclosure may include detecting DC link voltage information of the power factor correction circuit by the at least one processor.

The method of controlling the electrical device including the power factor correction circuit according to an embodiment of the disclosure may include obtaining, by the at least one processor, input voltage information of the electrical device based on the input voltage information and the detected DC link voltage information.

The method of controlling the electrical device including the power factor correction circuit according to an embodiment of the disclosure may include comparing, by the at least one processor, the obtained input voltage information with preset reference voltage information so as to determine whether an input voltage of the electrical device is a low voltage or a high voltage.

The method of controlling the electrical device including the power factor correction circuit according to an embodiment of the disclosure may include setting, by the at least one processor, a protection level of the power factor correction circuit according to the determined input voltage.

The method of controlling the electrical device including the power factor correction circuit according to an embodiment of the disclosure may include controlling, by the at least one processor, an operating cycle of a switch included in the power factor correction circuit based on the set protection level.

Description of Drawings

FIG. 1 is a circuit diagram of an electrical device including a power factor correction circuit.

FIG. 2 is an example diagram showing relationship between an output voltage of a PFC circuit and inrush current, when an input alternating current voltage applied as input power increases while an electrical device operates.

FIG. 3 is a block diagram of an electrical device according to an embodiment of the disclosure.

FIG. 4 is an example diagram showing changes in an overvoltage protection level of a PFC circuit and a direct current (DC) link voltage level being boosted, when input power provided from an input power source is a low voltage of 110 $V_{ac}$, according to an embodiment of the disclosure.

FIG. 5 is an example diagram showing boosting of a DC link voltage for improving efficiency in a low-load condition when an input voltage is a low voltage, according to an embodiment of the disclosure.

FIG. 6 is a functional block diagram of a processor according to an embodiment of the disclosure.

FIG. 7 is an operation flowchart illustrating an operation of setting a protection level of a PFC circuit according to an input voltage by a processor, according to an embodiment of the disclosure.

FIG. 8 is a flowchart illustrating operations by a processor, when an input voltage is determined to be a low voltage and a DC link voltage is in an overcharged state, according to an embodiment of the disclosure.

FIG. 9 is a configuration block diagram of an electrical device according to an embodiment of the disclosure.

FIG. 10 is an example diagram showing relationship between inrush current and rising slopes of a DC link voltage of a PFC circuit according to an embodiment of the disclosure.

FIG. 11 is a configuration block diagram of a processor shown in FIG. 9.

FIG. 12 is a configuration block diagram of an electrical device according to an embodiment of the disclosure.

FIG. 13 is a configuration block diagram of a processor shown in FIG. 12.

FIG. 14 is a configuration block diagram of an electrical device according to an embodiment of the disclosure.

FIG. 15 is a flowchart illustrating operations of an electrical device according to an embodiment of the disclosure.

FIG. 16 is a flowchart illustrating operations of an electrical device according to an embodiment of the disclosure.

FIG. 17 is a flowchart illustrating operations of an electrical device according to an embodiment of the disclosure.

Mode for Invention

Terms used in the disclosure will be briefly described, and an embodiment of the disclosure will be described in detail.

Throughout the disclosure, the expression "at least one of a, b or c" indicates only a, only b, only c, both a and b, both a and c, both b and c, all of a, b, and c, or variations thereof.

Although general terms being currently widely used were selected as terminology used in the disclosure while considering the functions in an embodiment of the disclosure, they may vary according to intentions of one of ordinary skill in the art, judicial precedents, the advent of new technologies, and the like. Also, terms arbitrarily selected by the applicant may also be used in a specific case. In this case, their meanings will be described in detail in the detailed description of the disclosure. Hence, the terms used in the disclosure must be defined based on the meanings of the terms and the entire content of the disclosure, not by simply stating the terms themselves.

Also, in the entire disclosure, it will be understood that when a certain part "includes" a certain component, the part does not exclude another component but can further include another component, unless the context clearly dictates otherwise. The terms "portion", "part", "module", and the like used in the disclosure refer to a unit used to process at least one function or operation, and may be implemented by hardware, software, or a combination thereof.

Hereinafter, an embodiment of the disclosure will be described in detail with reference to the accompanying drawings so that one of ordinary skill in the technical art to which the disclosure pertains can easily carry out the embodiment. However, the embodiment of the disclosure may be implemented in different forms, without being limited to the embodiment described herein. In the drawings, parts that are irrelevant to the descriptions may be not shown in order to clearly describe the embodiment of the disclosure. Throughout the entire disclosure, similar parts will be assigned similar reference numerals.

According to an embodiment of the disclosure, an electrical device capable of protecting an element by actively changing a protection level of a power factor correction (PFC) circuit based on an input voltage, and a method for controlling the electrical device may be provided.

According to an embodiment of the disclosure, an electrical device capable of improving efficiency degradation due to conduction losses at a low input voltage by actively changing a Direct Current (DC) link voltage of a PFC circuit based on an input voltage, and a method for controlling the electrical device may be provided.

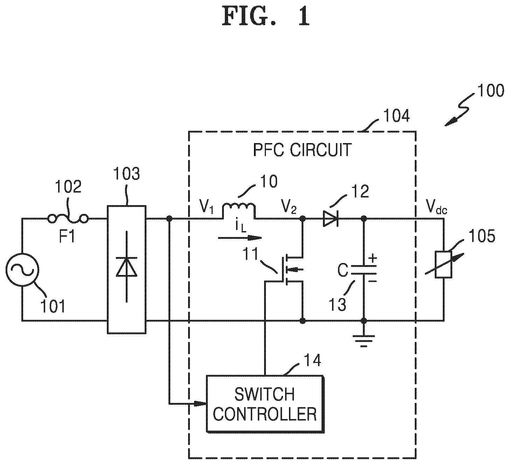

FIG. 1 is a circuit diagram of an electrical device 100 including a power factor correction (hereinafter abbreviated as PFC) circuit.

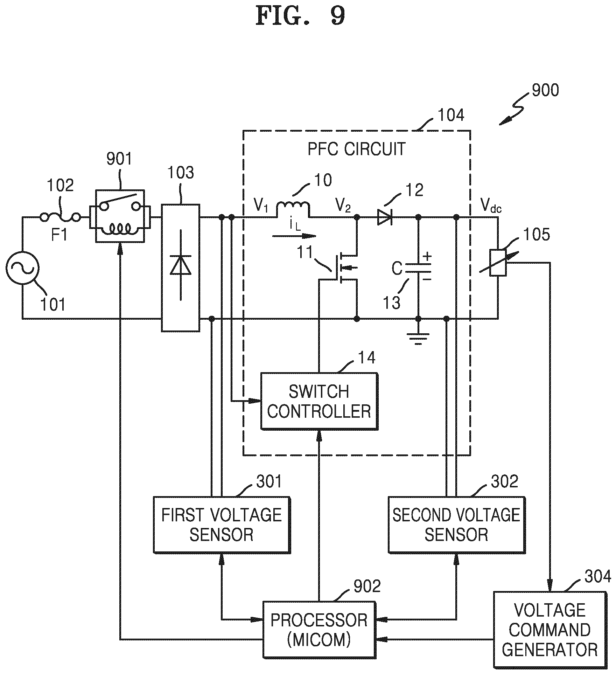

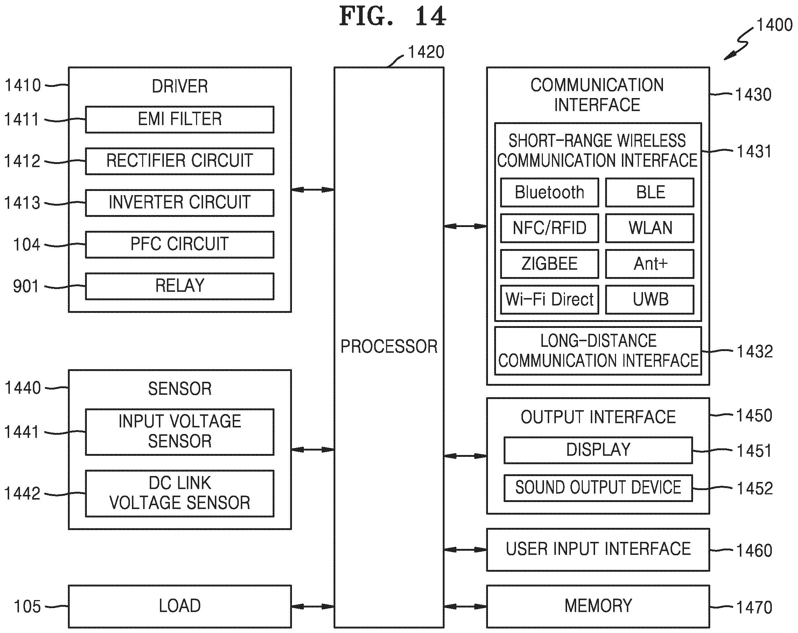

The electrical device 100 shown in FIG. 1 may include an input power source 101, a fuse 102, a bridge diode 103, a PFC circuit 104, and a load 105, although not limited thereto. For example, the electrical device 100 may further include at least one processor 303, 902, 1201, or 1420 which will be described below. The processor 303, 902, 1201, or 1420 may be a component for controlling functions of the electrical device 100 and may be configured as a Micom. For example, the electrical device 100 may further include a relay 901 and an Electro-Magnetic Interference (EMI) filter 1411, which will be described below, between the fuse 102 and the bridge diode 103. The relay 901 of FIG. 9 which will be described below may be a component that is controlled by the at least one processor 902, separately from the fuse 102, and protects a circuit element from input power or inrush current. The EMI filter 1411 of FIG. 14 which will be described below may be a component that removes high-frequency noise applied from the input power source 101.

The input power source 101 shown in FIG. 1 may be an alternating current (AC) power source having a low voltage, a high voltage, or a voltage according to universal standards. For example, the low voltage may include 110 $V_{ac} \pm$ 10% or 127 $V_{ac}$, although not limited thereto. 110 $V_{ac}$ mentioned below is an example of a low voltage mentioned in an embodiment of the disclosure and may be replaced with a low voltage of another value. The high voltage may include 220 $V_{ac} \pm$ 10% or 230 $V_{ac}$, although not limited thereto. 220 $V_{ac}$ mentioned below is an example of a high voltage mentioned in an embodiment of the disclosure and may be replaced with a high voltage of another value. The voltage according to the universal standards may range from 85 $V_{ac}$ to 265 $V_{ac}$, although not limited thereto.

The input power source 101 may be an alternating current power source through a power line connected to a power outlet. The input power source 101 may be a receiver that receives alternating current power wirelessly from a station (not shown) according to wireless power transmission.

The fuse 102 shown in FIG. 1 may be a safety device that protects a circuit located behind by being disconnected when a magnitude of input current provided from the input power source 101 reaches a limit value or more. The bridge diode 103 may be a component that rectifies an input alternating current voltage, and may function to convert an alternating current voltage input through the fuse 102 into a Direction Current (DC) voltage. Accordingly, the bridge diode 103 may also be referred to as a rectifier.

Because the PFC circuit 104 shown in FIG. 1 generates an output voltage $V_{dc}$ by boosting a direction current voltage $V_1$ transmitted from the bridge diode 103, the PFC circuit 104 may also be expressed as a boost converter. The output voltage $V_{dc}$ may be a voltage across both terminals of a capacitor 13, and may also be expressed as a DC link voltage. The PFC circuit 104 may secure operating performance of the load 105 even when a low voltage is applied from the input power source 101 by setting a maximum DC link voltage level when a voltage of the input power source 101 is 110 $V_{ac}$ to be equal to a maximum DC link voltage level when a voltage of the input power source 101 is 220 $V_{ac}$. For example, securing the operating performance of the load 105 in the case in which the load 105 is a compressor motor of an outdoor unit of an air conditioner may mean that the performance of the compressor motor is secured even when a low voltage is applied. That the performance of the motor is secured may mean that a required voltage of the motor based on an operation of the motor corresponds to a DC link voltage provided to the load 105.

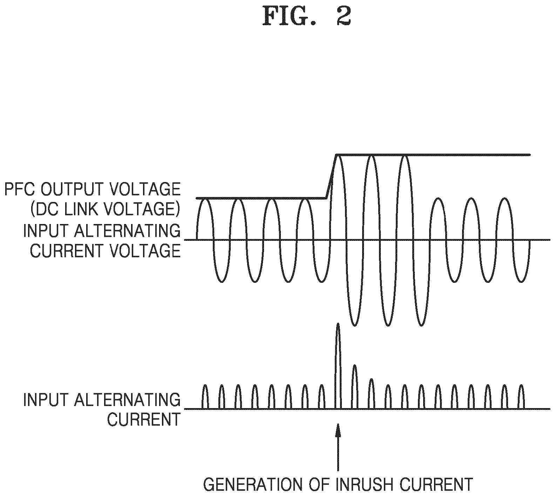

FIG. 2 is an example diagram showing relationship between an output voltage $V_{dc}$ of the PFC circuit 104 and inrush current when an input alternating current voltage applied as input power increases while the electrical device 100 operates. Inrush current may be generated in input alternating current when an input alternating current voltage applied from the input power source 101 changes sharply. For example, when an input alternating current voltage applied from the input power source 101 abruptly changes from a low voltage to a high voltage while the electrical device 100 operates, inrush current may be generated at a time as shown in FIG. 2, in order to charge the capacitor 13 included in the PFC circuit 104.

By controlling a turn-on or turn-off cycle of a switch 11 included in the PFC circuit 104 based on a protection level of the PFC circuit 104, the switch 11 and the capacitor 13 included in the PFC circuit 104 may be protected against inrush current generated as shown in FIG. 2, and the electrical device 100 may prevent damage to the fuse 103 or the bridge diode 103 which is a surrounding component of the PFC circuit 104, the relay 901 shown in FIG. 9, which will be described below, or the EMI filter 1411 shown in FIG. 14, which will be described below. Controlling the turn-on or turn-off cycle of the switch 11 may include changing a turn-on or turn-off cycle of the switch 11.

A component included in the electrical device 100 may be expressed as an element. For example, the fuse 102 and the bridge diode 103 shown in FIG. 1 may be expressed as elements. An inductor 10, the switch 11, a diode 12, and the capacitor 13 included in the PFC circuit 104 may be expressed as elements.

In regard to the PFC circuit 104 shown in FIG. 1, an input voltage $V_1$ may be expressed as a primary DC voltage, and an output voltage $V_{dc}$ may be expressed as a secondary DC voltage. The PFC circuit 104 may improve a power factor of the electrical device 100 by detecting a phase of the primary DC voltage $V_1$ and controlling a phase difference between a voltage and current to be 0 (zero). A power factor may represent a ratio of power (effective power) effectively acting on the load 105 with respect to power (apparent power) transferred from the input power source 101. Therefore, a low power factor indicates low energy efficiency of the electrical device 100, and a high power factor indicates high energy efficiency of the electrical device 100.

The PFC circuit 104 shown in FIG. 1 may include the inductor (or reactor) 10, the switch 11, the diode 12, the capacitor 13, and a switch controller 14. However, the PFC circuit 104 is not limited thereto. One end of the inductor 10 may be connected to an output terminal of the bridge diode 103, and another end of the inductor 10 may be connected to an anode of the diode 12. A cathode of the diode 12 may be connected to a terminal of the capacitor 13, and another terminal of the capacitor 13 may be connected to a ground. A drain terminal of the switch 11 may be connected to a node between the inductor 10 and the diode D, a source terminal of the switch 11 may be connected to the ground, and a gate terminal of the switch 11 may be connected to an output terminal of the switch controller 14. In FIG. 1, the switch 11 is configured as a Metal Oxide Semiconductor Field Effect Transistor (MOSFET), although not limited thereto. However, the switch 11 may be another switching element such as a Bipolar Junction Transistor (BJT).

The PFC circuit 104 shown in FIG. 1 may control a turn-on or turn-off cycle of the switch 11 by a control signal transmitted from the switch controller 14 to generate a boosted output voltage $V_{dc}$ from a voltage $V_2$ input to the capacitor 13, while preventing damage to the switch 11 and the capacitor 13 due to application of an overvoltage. The output voltage $V_{dc}$ may be maximally between 360 $V_{dc}$ and 400 $V_{dc}$, although not limited thereto.

In the PFC circuit 104 shown in FIG. 1, when the switch 11 is turned on, a voltage $V_1$ applied to the inductor 10 may become identical to an output voltage $V_2$ of the inductor 10 and no current may flow to the diode 12. Accordingly, energy may be accumulated in the inductor 10. In the PFC circuit 104, when the switch 11 is turned off, current of the inductor 10 may flow to the capacitor 13 via the diode 12, and a boosted output voltage $V_{dc}$ may be provided to the load 105. At this time, a voltage of the inductor 10 may become $V_1 - V_{dc}$, resulting in a minus voltage. The PFC circuit 104 may improve a power factor by controlling turn-on and turn-off operations of the switch 11 such that an average of voltages across the inductor 10 becomes 0 (zero) during one cycle of the switch 11 being turned on and then off. Controlling the turn-on and turn-off operations of the switch 11 may include changing a turn-on and turn-off cycle of the switch 11.

Based on a protection level of the PFC circuit 104 set according to an embodiment of the disclosure, a turn-on or turn-off cycle of the switch 11 may be controlled by the switch controller 14 included in the PFC circuit 104. The protection level of the PFC circuit 104 may include at least one or all of an overvoltage protection level, an undervoltage protection level, or an input current limit level, although not limited thereto. For example, the protection level of the PFC circuit 104 may include an overvoltage protection level. For example, the protection level of the PFC circuit 104 may include an undervoltage protection level. For example, the protection level of the PFC circuit 104 may include an input current limit level. For example, the protection level of the PFC circuit 104 may include an overvoltage protection level and an undervoltage protection level. For example, the protection level of the PFC circuit 104 may include an overvoltage protection level and an input current limit level. For example, the protection level of the PFC circuit 104 may include an undervoltage protection level and an input current limit level. For example, the protection level of the PFC circuit 104 may include an overvoltage protection level, an undervoltage protection level, and an input current limit level. The protection level of the PFC circuit 104 may be aimed to prevent damage to components included in the electrical device 100 against inrush current that may be generated in a poor power supply environment. The protection level of the PFC circuit 104 may be aimed to prevent damage to the components included in the electrical device 100 against an overvoltage that may be generated in a poor power supply environment. The protection level of the PFC circuit 104 may be aimed to prevent damage to the components included in the electrical device 100 against inrush current and an overvoltage that may be generated in a poor power supply environment.

The overvoltage protection level may be set based on a maximum voltage that the components included in the electrical device 100 can withstand. Particularly, when the input power source 101 is a low voltage, the overvoltage protection level may change based on a DC link boost command voltage according to an operation of the load 105. The switch controller 14 of FIG. 1 may be configured to control an operation of the switch 11 based on input current of the PFC circuit 104. However, the switch controller 14 may be configured to receive a DC link boost command voltage through another side. The switch controller 14 may be configured to receive an input voltage of the PFC circuit 104. The DC link boost command voltage may be based on a motor required voltage depending on operating speed of a motor (not shown) included in the load 105. The undervoltage protection level may be set to prevent damage to the components included in the electrical device 100 against inrush current. The input current limit level may be set to maintain a maximum of an output voltage $V_{dc}$ of the PFC circuit 104 within an allowable current range of elements.

The overvoltage protection level, the undervoltage protection level, or/and the input current limit level may be set differently depending on whether power applied to the input power source 101 is a low voltage or a high voltage. The overvoltage protection level, the undervoltage protection level, or/and the input current limit level may be set in consideration of a voltage variation range per hour in a poor power supply region where rapid variations in voltage may occur while the electrical device 100 operates.

The load 105 shown in FIG. 1 may secure operating performance by the boosted output voltage $V_{dc}$ of the PFC circuit 104 even when the input power source 101 is a low voltage. The load 105 may be a compressor motor or a fan motor included in an outdoor unit of an air conditioner, although not limited thereto. For example, the load 105 may include a battery charger or a standard charging for charging a battery of an electric vehicle, a fan motor or a compressor motor of a refrigerator, a motor of a washing machine, or a motor of a cleaner. Securing the operating performance may mean providing a voltage required to operate the load 105.

The load 105 shown in FIG. 1 may need to use a component with a sufficiently large margin in consideration of a variation range because the input power source 101 can apply both 110 $V_{ac}$ and 220 $V_{ac}$. However, because a protection level of the PFC circuit 104 changes depending on a voltage of power applied through the input power source 101, a component with a large margin in consideration of the variation range of the input power source 101 may not need to be used. Accordingly, it may be possible to prevent the size of the electrical device 100 from increasing or the manufacturing cost of the electrical device 100 from increasing due to the load 105.

The electrical device 100 shown in FIG. 1 may be an electronic product including the PFC circuit 104, such as an outdoor unit of an air conditioner, an electric vehicle, a refrigerator, a home appliance, a power control device, or an Alternating Current-Direct Current (AC-DC) power supply, etc., although not limited thereto. For example, the electrical device 100 may include an air conditioner, a washing machine, a dryer, a lamp, a television (TV), a heater, a cleaner, or a styler. The heater may include a smart kettle, an induction device, an air fryer, or a rice cooker, etc., although not limited thereto.

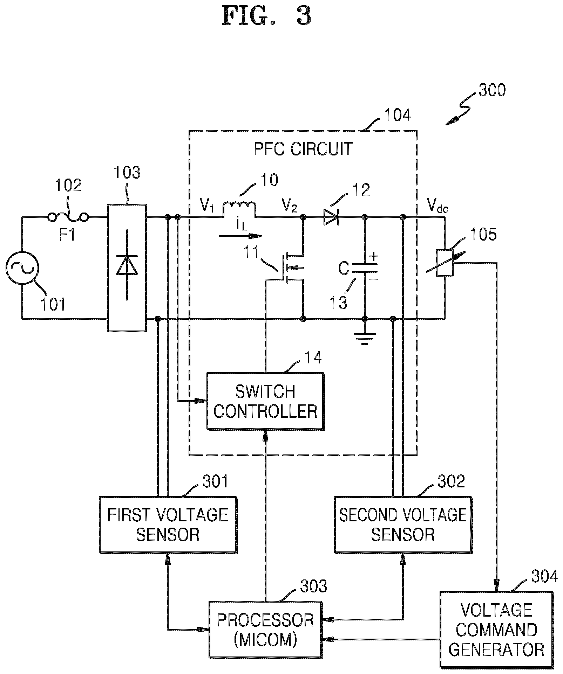

FIG. 3 is a block diagram of an electrical device 300 according to an embodiment of the disclosure.

The electrical device 300 shown in FIG. 3 may include the input power source 101, the fuse 102, the bridge diode 103, the PFC circuit 104, the load 105, a first voltage sensor 301, a second voltage sensor 302, the processor 303, and a voltage command generator 304, although not limited thereto. For example, the electrical device 300 shown in FIG. 3 may further include the relay 901 which will be described below and the EMI filter 1411 mentioned in FIG. 14, which will be described below.

The input power source 101 may be an alternating current (AC) power source having a low voltage, a high voltage, or a voltage according to universal standards. For example, the low voltage may include 110 $V_{ac}$ ± 10% or 127 $V_{ac}$, although not limited thereto. 110 $V_{ac}$ mentioned below is an example of a low voltage mentioned in an embodiment and may be replaced with a low voltage of another value. The high voltage may include 220 $V_{ac}$ ± 10% or 230 $V_{ac}$, although not limited thereto. 220 $V_{ac}$ mentioned below is an example of a high voltage mentioned in an embodiment and may be replaced with a high voltage of another value. The voltage according to the universal standards may range from 85 $V_{ac}$ to 265 $V_{ac}$, although not limited thereto.

The input power source 101 may be an alternating current power source through a power line connected to a power outlet. The input power source 101 may be a receiver that receives alternating current power wirelessly from a station (not shown) according to wireless power transmission.

The fuse 102 shown in FIG. 3 may be a safety device that protects a circuit downstream by automatically disconnected when a magnitude of input current provided from the input power source 101 reaches a limit value or more. The bridge diode 103 may be a component that acts as a rectifier to convert an alternating current voltage input through the fuse 102 into a direct current (DC) voltage. Accordingly, the bridge diode 103 may also be referred to as a rectifier.

Because the PFC circuit 104 shown in FIG. 3 generates an output voltage $V_{dc}$ by boosting a DC voltage $V_1$ transmitted from the bridge diode 103, the PFC circuit 104 may also be expressed as a boost converter. The output voltage $V_{dc}$ may be a voltage across both terminals of the capacitor 13, and may also expressed as a DC link voltage. The PFC circuit 104 may secure operating performance of the load 105 even when a low voltage is applied from the input power source 101, in a poor power supply region, by setting maximum DC link voltage information when a voltage of the input power source 101 is 110 $V_{ac}$ to be the same as maximum DC link voltage information when a voltage of the input power source 101 is 220 $V_{ac}$. The maximum DC link voltage information may also be referred to as a maximum DC link voltage level or a maximum DC link voltage value. For example, securing operating performance of the load 105 in the case in which the load 105 is a compressor motor of an outdoor unit of an air conditioner may mean that the performance of the compressor motor is secured even when a low voltage is applied. That the performance of the motor is secured may mean that the motor required voltage based on an operation of the motor corresponds to a DC link voltage provided to the load 105. For example, in the case in which the load 105 is a battery charger or a standard charging for charging a battery of an electric vehicle, securing the operating performance of the load 105 may mean that a required operation voltage based on an operation of the battery charger or the standard charging corresponds to a DC link voltage provided to the load 105 even when a low voltage is applied.

The first voltage sensor 301 may sense an input voltage $V_1$ of the PFC circuit 104. Sensing the input voltage $V_1$ of the PFC circuit 104 may be expressed as sensing input voltage information or an input voltage value of the PFC circuit 104. The first voltage sensor 301 may be configured with a resistor or a capacitor, although not limited thereto.

The second voltage sensor 302 may sense an output voltage $V_{dc}$ of the PFC circuit 104. Sensing the output voltage $V_{dc}$ of the PFC circuit 104 may be expressed as sensing output voltage information, an output voltage value, DC link voltage information, or a DC link voltage value of the PFC circuit 104. The second voltage sensor 302 may be configured with a resistor or a capacitor, although not limited thereto.

The processor 303 may read voltage information sensed by the first voltage sensor 301 and the second voltage 302. The processor 303 may receive voltage information sensed by the first voltage sensor 301 and the second voltage 302. The voltage information read from the first voltage sensor 301 may also be expressed as first voltage information. The first voltage information may also be expressed as input voltage information, an input voltage value, or an input voltage. The voltage information read from the second voltage sensor 302 may also be expressed as second voltage information. The second voltage information may also be expressed as an output voltage, output voltage information, a DC link voltage, or DC link voltage information.

The processor 303 may obtain input voltage information based on the first voltage information and the second voltage information. The processor 303 may compare the first voltage information with the second voltage information, and when the first voltage information is the same as the second voltage information, the processor 303 may obtain the same information as input voltage information. The processor 303 may compare the first voltage information with the second voltage information, and when the first voltage information is different from the second voltage information, the processor 303 may obtain the first voltage information as input voltage information.

For example, according to the first voltage information being 110 $V_{ac}$ (or 127 $V_{ac}$) and the second voltage information being 110 $V_{ac}$ (or 127 $V_{ac}$), the processor 303 may obtain 110 $V_{ac}$ (or 127 $V_{ac}$) as input voltage information. For example, according to the first voltage information being 110 $V_{ac}$ (or 127 $V_{ac}$) and the second voltage information being 130 $V_{ac}$ (or 147 $V_{ac}$), the processor 303 may obtain 110 $V_{ac}$ (or 127 $V_{ac}$) as input voltage information. The second voltage information of 130 $V_{ac}$ (or 146 $V_{ac}$) may be due to boosting by the PFC circuit 104. According to the first voltage information being 220 $V_{ac}$ (or 230 $V_{ac}$) and the second voltage information being 220 $V_{ac}$ (or 230 $V_{ac}$), the processor 303 may obtain 220 $V_{ac}$ (or 230 $V_{ac}$) as input voltage information. For example, according to the first voltage information being 220 $V_{ac}$ (or 230 $V_{ac}$) and the second voltage information being 235 $V_{ac}$ (or 245 $V_{ac}$), the processor 303 may obtain 220 $V_{ac}$ (or 230 $V_{ac}$) as input voltage information. The second voltage information of 235 $V_{ac}$ (or 245 $V_{ac}$) may be due to boosting by the PFC circuit 104.

After the processor 303 obtains the input voltage information, the processor 303 may compare the obtained input voltage information with preset reference voltage information to determine whether the input voltage is a low voltage or a high voltage. The preset reference voltage information may be expressed as reference information for determining whether an input voltage is a low voltage or a high voltage based on a variation range of the input voltage. The preset reference voltage information may be stored in the processor 303 or a memory 1470 of FIG. 14, which will be described below. The memory 1470 may be included in the electrical device 300. In the case in which the reference voltage information is stored in the memory 1470, the processor 303 may read the reference voltage information from the memory 1470 and use the reference voltage information. For example, the preset reference voltage information may be set to 165 $V_{ac}$, although not limited thereto.

According to the obtained input voltage information being 165 $V_{ac}$ or less, the processor 303 may determine the input voltage applied from the input power source 101 to be a low voltage. According to the obtained input voltage information exceeding 165 $V_{ac}$, the processor 303 may determine the input voltage applied from the input power source 101 to be a high voltage. After the processor 303 determines the input voltage to be a low voltage or a high voltage, the processor 303 may re-determine whether the input voltage is a low voltage or a high voltage.

To prevent a situation of continuing to monitor input voltage information when the input voltage information is re-determined, the processor 303 may apply hysteresis. For example, the processor 303 may prevent re-determination due to voltage fluctuations through hysteresis of about 30 $V_{ac}$ based on a previously determined voltage. For example, when input voltage information obtained after an input voltage applied from the input power source 101 is determined to be a low voltage of 110 $V_{ac}$ is 180 $V_{ac}$ or more, the processor 303 may determine an input voltage applied from the input power source 101 to be a high voltage of 220 Vac. For example, when input voltage information obtained after an input voltage applied from the input power source 101 is determined to be a high voltage of 220 $V_{ac}$ is 150 $V_{ac}$ or less, the processor 303 may determine an input voltage applied from the input power source 101 to be a low voltage of 110 $V_{ac}$.

After the processor 303 determines whether the input voltage applied from the input power source 101 is a low voltage or a high voltage, the processor 303 may set a protection level of the PFC circuit 104 based on the determined input voltage. The protection level may include at least one or all of an overvoltage protection level, an undervoltage protection level, or an input current limit level, although not limited thereto. For example, the processor 303 may set an overvoltage protection level of the PFC circuit 104. For example, the processor 303 may set an undervoltage protection level of the PFC circuit 104. For example, the processor 303 may set an input current limit level of the PFC circuit 104. For example, the processor 303 may set an overvoltage protection level and an undervoltage protection level of the PFC circuit 104. For example, the processor 303 may set an overvoltage protection level and an input current limit level of the PFC circuit 104. For example, the processor 303 may set an undervoltage protection level and an input current limit level of the PFC circuit 104.

For example, the processor 303 may set an overvoltage protection level and an undervoltage protection level when a determined input voltage is a low voltage to be lower than an overvoltage protection level and an undervoltage protection level when an input voltage is a high voltage. The overvoltage protection level may also be expressed as an overvoltage level, an overvoltage protection value, or an overvoltage value. The undervoltage protection level may also be expressed as an undervoltage level, an undervoltage protection value, or an undervoltage value. Also, the processor 303 may set an input current limit level when an input voltage is a low voltage to be higher than an input current limit level when an input voltage is a high voltage. The input current limit level may also be expressed as an input current limit value or an input current level.

For example, when an input voltage applied from the input power source 101 is a low voltage of 110 $V_{ac}$, the processor 303 may set an undervoltage protection level of the PFC circuit 104 to 65 $V_{ac}$, an overvoltage protection level of the PFC circuit 104 to 210 $V_{ac}$, and an input current limit level of the PFC circuit 104 to 30A, although not limited thereto. For example, when an input voltage applied from the input power source 101 is a high voltage of 220 $V_{ac}$, the processor 303 may set an undervoltage protection level of the PFC circuit 104 to 140 $V_{ac}$, an overvoltage protection level of the PFC circuit 104 to 270 $V_{ac}$, and an input current limit level of the PFC circuit 104 to 25A, although not limited thereto. As such, by setting, by the processor 303, at least one of an overvoltage protection level, an undervoltage protection level, or an input current limit level depending on an input voltage applied from the input power source 101, as described above, damage to the PFC circuit 104 and the components included in the electrical device 300 may be prevented.

Also, in order to secure performance of the load 105, the processor 303 may control a boosting operation of the PFC circuit 104 such that a DC link maximum boost level of the PFC circuit 104 when an input voltage applied from the input power source 101 is a low voltage of 110 $V_{ac}$ is equal to a DC link maximum boost level when an input voltage applied from the input power source 101 is 220 $V_{ac}$. Securing the performance of the load 105 may mean supplying power to enable the load 105 to perform a desired operation at desired speed. For example, securing the performance of the load 105 may be expressed as supplying, in the case in which the load 105 is a compressor motor of an air conditioner, power to provide performance of the compressor motor required by the air conditioner. Supplying the power to provide the required performance of the compressor motor may mean supplying a DC link voltage to provide the required performance of the compressor motor. The required performance of the compressor motor may be expressed as a required voltage based on an operation of the compressor motor.

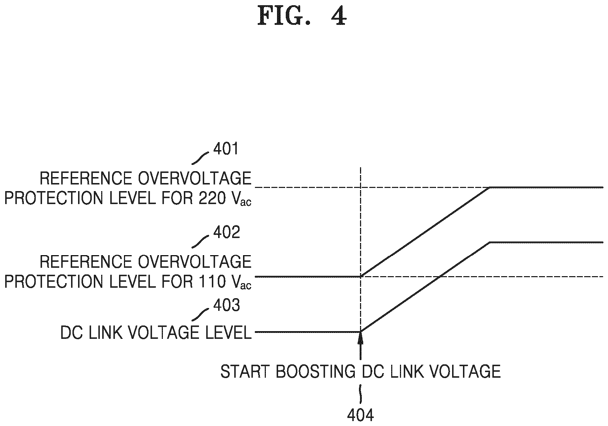

Because the processor 303 controls a DC link maximum boost level of the PFC circuit 104 when an input voltage applied from the input power source 101 is a low voltage to be equal to a DC link maximum boost level of the PFC circuit 104 when an input voltage applied from the input power source 101 is a high voltage, a DC link voltage of the PFC circuit 104 may exceed a reference overvoltage protection level for a low voltage of 110 $V_{ac}$, which may result in generation of an overvoltage error. To prevent the generation of the overvoltage error, when the processor 303 boosts a DC link voltage of the PFC circuit 104 according to a voltage command provided from the voltage command generator 304, the processor 303 may perform a control of increasing an overvoltage protection level of 110 $V_{ac}$ together, as shown in FIG. 4. A maximum increase value of the overvoltage protection level may be limited to a reference overvoltage protection level for a high voltage of 220 $V_{ac}$ set based on specifications of the capacitor 13 or the switch 11, as shown in FIG. 4.

FIG. 4 is an example diagram showing changes in an overvoltage protection level of the PFC circuit 104 and a DC link voltage level being boosted, when input power provided from the input power source 101 is a low voltage of 110 $V_{ac}$, according to an embodiment of the disclosure. As shown in FIG. 4, an overvoltage protection level for a low voltage of 110 $V_{ac}$ may increase at the same rate as a DC link voltage level from a time at which the DC link voltage starts being boosted, and a maximum value of the overvoltage protection level for the low voltage of 110 $V_{ac}$ may correspond to a reference overvoltage protection level for a high voltage of 220 $V_{ac}$.

For example, when an input voltage applied from the input power source 101 is a high voltage of 220 $V_{ac}$ and a DC link voltage is boosted up to a maximum of 360 $V_{dc}$, a DC link voltage for a low voltage of 110 $V_{ac}$ may be set to be boosted up to the maximum of 360 $V_{dc}$. Accordingly, when a reference overvoltage level for a low voltage of 110 $V_{ac}$ is 210 $V_{ac}$ (297 $V_{dc}$), the DC link maximum voltage level of 360 $V_{ac}$ through boosting by the PFC circuit 104 may be higher than the reference overvoltage protection level of 297 $V_{dc}$, and therefore, an overvoltage error may be generated. To prevent the generation of such an overvoltage error, an overvoltage level may be controlled to increase together with a DC link voltage being boosted. The processor 303 may increase an overvoltage level of the PFC circuit 104 in proportion to a DC link voltage of the PFC circuit 104. An overvoltage protection level for a high voltage of 220 $V_{ac}$ may be 380 $V_{dc}$, although not limited thereto. For example, an overvoltage protection level for 220 $V_{ac}$ may be set to 400 $V_{dc}$.

To compensate for low operating efficiency of the load 105 due to an increase in current at a low input voltage of 110 $V_{ac}$ applied from the input power source 101 compared to a high input voltage of 220 $V_{ac}$, the processor 303 may set a voltage value at which a DC link voltage for a low voltage of 110 $V_{ac}$ starts being boosted to be lower than a voltage value at which a DC link voltage for a high voltage of 220 $V_{ac}$ starts being boosted. Accordingly, the operating efficiency of the load 105 may increase even when an input voltage applied from the input power source 101 is a low voltage. Increasing the operating efficiency of the load 105 may mean improving the performance of the load 105 as described above.

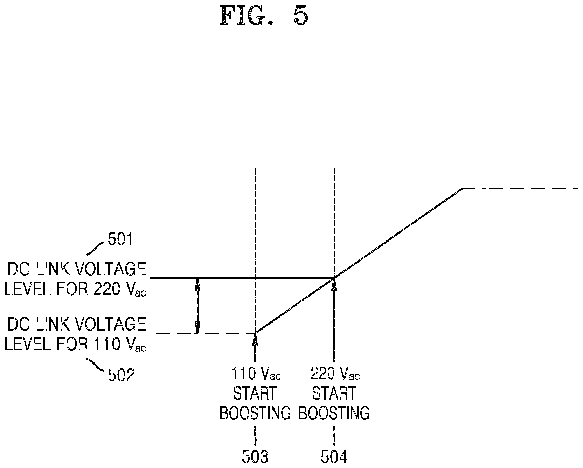

FIG. 5 is an example diagram showing boosting of a DC link voltage for improving efficiency in a low-load condition when an input voltage is a low voltage, according to an embodiment of the disclosure.

For example, when an input voltage applied from the input power source 101 is a high voltage of 220 $V_{ac}$, boosting may start at 311 $V_{dc}$ or more, whereas, in the case of a low voltage of 100 $V_{ac}$, boosting may start at 155 $V_{dc}$ or more. Accordingly, at a low voltage of 110 $V_{ac}$, the PFC circuit 104 may use a boosting voltage within a range of 155 $V_{dc}$ to 311 $V_{dc}$. As such, by lowering a boosting voltage at an area where the load 105 is low, switching loss may be lowered, which may result in an improvement of performance efficiency of the load 105. Improving the performance efficiency of the load 105 may mean supplying required power of the load 105. Although, in a high-speed area where the required power of the load 105 is high, efficiency may be lower than that of 220 $V_{ac}$, the operating efficiency of the load 105 in a low-speed area where the required voltage of the load 105 is low may be improved.

The voltage command generator 304 of FIG. 3 may generate a voltage command determined according to a required voltage of the load 105 and transmit the generated voltage command to the processor 303. For example, in the case in which the load 10 is a motor, a required voltage may be expressed as a motor required voltage. Hereinafter, a motor required voltage may mean a required voltage based on an operation of the load 105. A voltage command generated by the low voltage command generator 304 may be expressed as a DC link command voltage of the PFC circuit 104. Accordingly, at a low voltage applied from the input power source 101, the processor 303 may change an overvoltage protection level of the PFC circuit 104 to increase the overvoltage protection level of the PFC circuit 104 according to an increase of a motor required voltage. A motor required voltage may be determined according to a D-axis voltage command and a Q-axis voltage command of a motor included in the load 105, as expressed by Equation 1 below. A motor required voltage may have a low voltage value at low speed of the motor included in the load 105, and a high voltage value at high speed of the motor included in the load 105.

[Equation 1]

$$V_m = (V_{ds}^2 + V_{qs}^2)^{1/2}$$

In Equation 1, $V_m$ is a motor required voltage, $V_{ds}$ is a D-axis voltage command, and $V_{qs}$ is a Q-axis voltage command. A motor required voltage according to an embodiment of the disclosure is not limited to Equation 1.

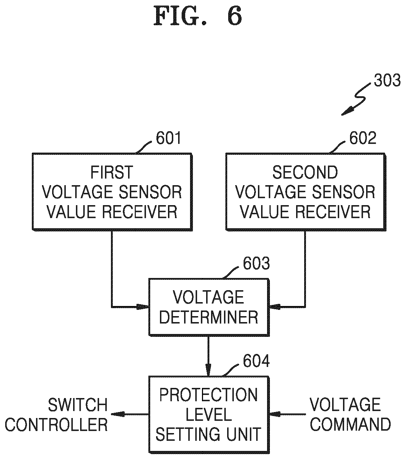

FIG. 6 is a functional block diagram of the processor 303 according to an embodiment of the disclosure.

Referring to FIG. 6, the processor 303 may include a first voltage sensor value receiver 601, a second voltage sensor value receiver 602, a voltage determiner 603, and a protection level setting unit 604, although not limited thereto.

The first voltage sensor value receiver 601 may be configured to read an input voltage sensed by the first voltage sensor 301. The first voltage sensor value receiver 601 may be configured to receive an input voltage sensed by the first voltage sensor 301. A configuration of the first voltage sensor value receiver 601 may depend on a configuration of the first voltage sensor 301. For example, the first voltage sensor value receiver 601 may determine a connection point to the first voltage sensor 301 depending on whether the first voltage sensor 301 is configured with a resistor or a capacitor.

The second voltage sensor value receiver 602 may be configured to read an input voltage sensed by the second voltage sensor 302. The second voltage sensor value receiver 602 may be configured to receive an input voltage sensed by the second voltage sensor 302. A configuration of the second voltage sensor value receiver 602 may depend on a configuration of the second voltage sensor 302. For example, the second voltage sensor value receiver 602 may determine a connection point to the second voltage sensor 302 depending on whether the second voltage sensor 302 is configured with a resistor or a capacitor.

The voltage determiner 603 may obtain an input voltage of the electrical device 300 based on input voltage information of the PFC circuit 104 received by the first voltage sensor value receiver 601 and DC link voltage information of the PFC circuit 104 received by the second voltage sensor value receiver 602. After the input voltage of the electrical device 300 is obtained, the voltage determiner 603 may compare the obtained input voltage with preset reference voltage information to determine whether the input voltage of the electrical device 300 is a low voltage or a high voltage. The preset reference voltage has been mentioned with reference to FIG. 3. For example, the preset reference voltage may be 165 $V_{ac}$. The voltage determiner 603 may be expressed as a voltage judgement unit or a voltage check unit. A unit may be expressed as a processor.

The protection level setting unit 604 may set a protection level of the PFC circuit 104 according to a voltage determined by the voltage determiner 603. The protection level of the PFC circuit 104 may include at least one or all of an overvoltage protection level, an undervoltage protection level, or an input current limit level, although not limited thereto. The protection level of the PFC circuit 104 may be aimed to prevent damage to components included in the electrical device 300 against inrush current that may be generated in a poor power supply environment.

The overvoltage protection level may be set based on a maximum voltage that the components included in the electrical device 300 can withstand. Particularly, when the input power source 101 is a low voltage, the overvoltage protection level may change based on a DC link boost command voltage according to an operation of the load 105. Accordingly, although the switch controller 14 of FIG. 1 is configured to control an operation of the switch 11 based on an input voltage of the PFC circuit 104, the switch controller 14 may be configured to receive a DC link boost command voltage through another side. Controlling the operation of the switch 11 may mean controlling an operating cycle of the switch 11. Controlling the operating cycle of the switch 11 may include changing an operating cycle of the switch 11.

The DC link boost command voltage may be based on a motor required voltage according to operating speed of the motor included in the load 105. The low voltage protection level may be set to prevent damage to the components included in the electrical device 300 against inrush current. The input current limit level may be set to maintain a maximum of an output voltage $V_{dc}$ of the PFC circuit 104.

The overvoltage protection level, the undervoltage protection level, or/and the input current limit level may be set differently depending on whether power applied to the input power voltage 101 is a low voltage or a high voltage. The overvoltage protection level, the undervoltage protection level, or the input current limit level may be set differently depending on whether power applied to the input power voltage 101 is a low voltage or a high voltage. The overvoltage protection level and the undervoltage protection level may be set differently depending on whether power applied to the input power voltage 101 is a low voltage or a high voltage. The input current limit level may be set differently depending on whether power applied to the input power voltage 101 is a low voltage or a high voltage. The overvoltage protection level, the undervoltage protection level, or/and the input current limit level may be set in consideration of a voltage variation range per hour in a poor power supply region where rapid variations in voltage may occur while the electrical device 100 operates.

The protection level setting unit 604 may set a protection level of the PFC circuit 104 based on a voltage command generated according to a motor required voltage transmitted from the load 105, as described with reference to FIG. 3. The voltage command may be expressed as a DC link voltage command.

Because the protection level setting unit 604 actively changes a protection level of the PFC circuit 104 according to an input voltage applied from the input power source 101, the protection level setting unit 604 may also be expressed as a protection level changing unit.

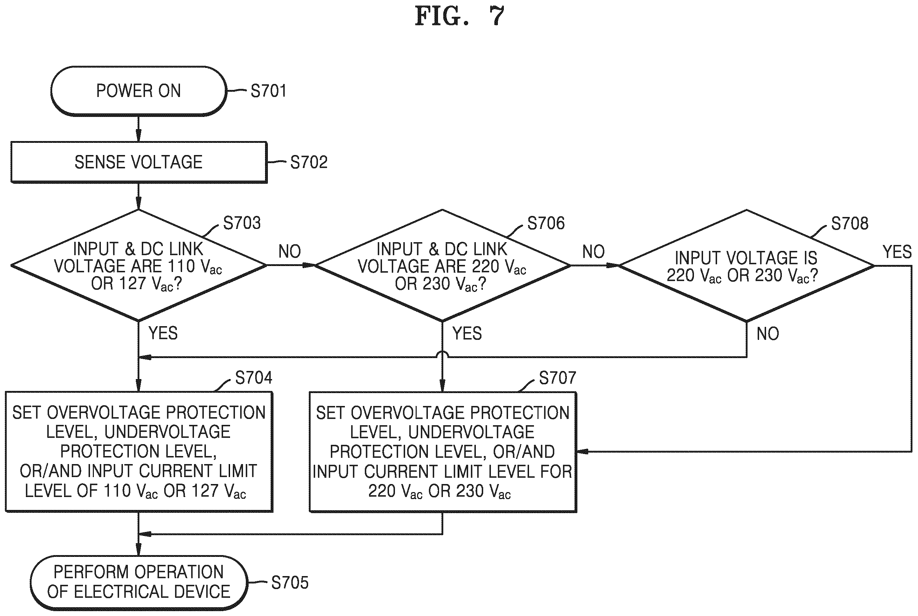

FIG. 7 is an operation flowchart illustrating an operation of setting a protection level of the PFC circuit 104 according to an input voltage by the processor 303, according to an embodiment of the disclosure.

When the electrical device 300 is powered on in operation S701, the processor 303 may sense a voltage in operation S702. Sensing the voltage in operation S702 may mean sensing both an input voltage of the PFC circuit 104 and a DC link voltage of the PFC circuit 104 by the processor 303. Sensing the voltage in operation S702 may mean reading or receiving an input voltage of the PFC circuit 104 from the first voltage sensor 301 and reading or receiving a DC link voltage of the PFC circuit 104 from the second voltage sensor 302, by the processor 303.

In operation S703, the processor 303 may determine whether the input voltage and the DC link voltage are low voltages of 110 $V_{ac}$ or 127 $V_{ac}$. According to the determined result that both the input voltage and the DC link voltage are low voltages of 110 $V_{ac}$ or 127 $V_{ac}$, the processor 303 may set an overvoltage protection level, an undervoltage protection level, or/and an input current limit level of the PFC circuit 104 to a level according to a low voltage of 110 $V_{ac}$ or 127 $V_{ac}$, in operation S704. Setting the protection level in operation S704 may be expressed as changing the protection level. The reason may be because the processor 303 may change an overvoltage protection level of the PFC circuit 104 to an undervoltage protection level in operation S704. In operation S704, the processor 303 may set an overvoltage protection level and an undervoltage protection level of the PFC circuit 104 to a level according to the low voltage of 110 $V_{ac}$ or 127 $V_{ac}$. In operation S704, the processor 303 may set an input current limit level of the PFC circuit 104 to a level according to the low voltage of 110 $V_{ac}$ or 127 $V_{ac}$. In operation S704, the processor 303 may set an overvoltage protection level of the PFC circuit 104 to a level according to the low voltage of 110 $V_{ac}$ or 127 $V_{ac}$. In operation S704, the processor 303 may set an undervoltage protection level of the PFC circuit 104 to a level according to the low voltage of 110 $V_{ac}$ or 127 $V_{ac}$.

In operation S705, the processor 303 may perform an operation of the electrical device 300 based on the set protection level. Performing the operation of the electrical device 300 may mean performing an operation of the load 105. Performing the operation of the load 105 may mean performing, in the case in which the load 104 is a compressor motor of an outdoor unit of an air conditioner, an operation of the compressor motor.

In operation S703, according to the determined result that the input voltage and the DC link voltage are not low voltages of 110 $V_{ac}$ or 127 $V_{ac}$, the processor 303 may proceed to operation S706 to determine whether the input voltage and the DC link voltage are high voltages of 220 $V_{ac}$ or 230 $V_{ac}$. In operation S706, according to the determined result that the input voltage and the DC link voltage are high voltages of 220 $V_{ac}$ or 230 $V_{ac}$, the processor 303 may set a protection level of the PFC circuit 104 to an overvoltage protection level, an undervoltage protection level, or/and an input current limit level for a high voltage of 220 $V_{ac}$ or 230 $V_{ac}$, in operation S707, and then proceed to operation S705. In operation S707, the protection level of the PFC circuit 104 may be set to an overvoltage protection level and an undervoltage protection level for a high voltage of 220 $V_{ac}$ or 230 $V_{ac}$. In operation S707, the protection level of the PFC circuit 104 may be set to an input current limit level for a high voltage of 220 $V_{ac}$ or 230 $V_{ac}$. In operation S707, the protection level of the PFC circuit 104 may be set to an overvoltage protection level for a high voltage of 220 $V_{ac}$ or 230 $V_{ac}$. In operation S707, the protection level of the PFC circuit 104 may be set to an undervoltage protection level for a high voltage of 220 $V_{ac}$ or 230 $V_{ac}$. In operation S707, the protection level of the PFC circuit 104 may be set to an overvoltage protection level and an input current limit level for a high voltage of 220 $V_{ac}$ or 230 $V_{ac}$. In operation S707, the protection level of the PFC circuit 104 may be set to an undervoltage protection level and an input current limit level for a high voltage of 220 $V_{ac}$ or 230 $V_{ac}$.

In operation S706, according to the determined result that the input voltage and the DC link voltage are not high voltages of 220 $V_{ac}$ or 230 $V_{ac}$, the processor 303 may determine whether the input voltage is a high voltage of 220 $V_{ac}$ or 230 $V_{ac}$, in operation S708. In operation S708, according to the determined result that the input voltage is a high voltage of 220 $V_{ac}$ or 230 $V_{ac}$, the processor 303 may proceed to operation S707 to set a protection level of the PFC circuit 104 to an overvoltage protection level, an undervoltage protection level, or/and an input current limit level for a high voltage of 220 $V_{ac}$ or 230 $V_{ac}$.

In operation S708, according to the determined result that the input voltage is not a high voltage of 220 $V_{ac}$ or 230 $V_{ac}$, the processor 303 may proceed to operation S704 to set an overvoltage protection level, an undervoltage protection level, or/and an input current limit level of the PFC circuit 104 to a level according to a low voltage of 110 $V_{ac}$ or 127 $V_{ac}$.

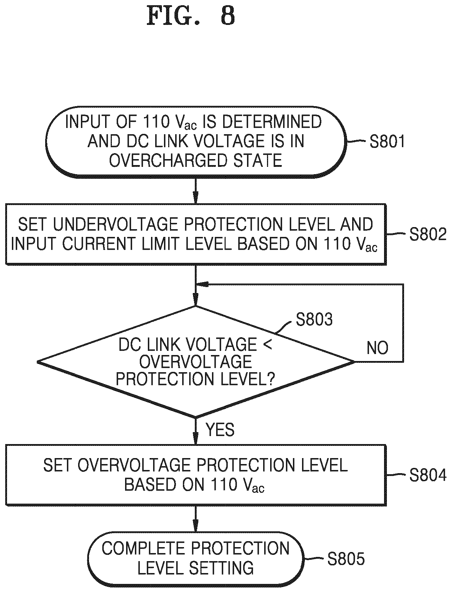

FIG. 8 is a flowchart illustrating operations by the processor 303, when an input voltage is determined to be a low voltage and a DC link voltage is in an overcharged state, according to an embodiment of the disclosure.

In operation S801, according to determination that an input voltage of the PFC circuit 104 is a low voltage of 110 $V_{ac}$ and a DC link voltage is in an overcharged state, the processor 303 may set an undervoltage protection level and an input current limit level of the PFC circuit 104 based on a low voltage of 110 $V_{ac}$, in operation S802.

In operation S803, the processor 303 may compare the DC link voltage of the PFC circuit 104 with a preset overvoltage protection level, and determine that the DC link voltage is lower than an overvoltage level for 110 $V_{ac}$, the processor 303 may set an overvoltage protection level of the PFC circuit 104 based on 110 $V_{ac}$ in operation S804, and treat a protection level setting process as completed in operation S805.

The embodiment shown in FIG. 8 may be expressed as readjusting an overvoltage protection level of the PFC circuit 104 based on an input voltage of the input power source 101 by comparing obtained DC link voltage information with a preset overvoltage protection level.

FIG. 9 is a configuration block diagram of an electrical device 900 according to an embodiment of the disclosure. The electrical device 900 shown in FIG. 9 is an example in which a component for turning the relay on or off by using a voltage rising slope is further added to the electrical device 300 of FIG. 3. The electrical device 900 shown in FIG. 9 may more safely protect elements included in the electrical device 900 against inrush current that may be applied by input current of the input power source 101 in a poor power supply environment, through the added component for turning the relay on or off based on a rising slope of a DC link voltage.

The electrical device 900 shown in FIG. 9 may include the input power source 101, the fuse 102, the relay 901, the bridge diode 103, the PFC circuit 104, the load 105, the first voltage sensor 301, and the second voltage sensor 302, the voltage command generator 304, and a processor 902, although not limited thereto. For example, the electrical device 900 shown in FIG. 9 may further include the EMI filter 1411 of FIG. 14, which will be described below.

The input power source 101 may be an AC power source having a low voltage, a high voltage, or a voltage according to universal standards. For example, the low voltage may include 110 $V_{ac}$ ± 10% or 127 $V_{ac}$, although not limited thereto. 110 $V_{ac}$ mentioned below is an example of a low voltage mentioned in an embodiment of the present disclosure and may be replaced with a low voltage of another value. The high voltage may include 220 $V_{ac}$ ± 10% or 230 $V_{ac}$, although not limited thereto. 220 $V_{ac}$ mentioned below is an example of a high voltage mentioned in an embodiment of the present disclosure and may be replaced with a high voltage of another value. The voltage according to the universal standards may range from 85 $V_{ac}$ to 265 $V_{ac}$, although not limited thereto.

The input power source 101 may be an alternating current power source through a power line connected to a power outlet. The input power source 101 may be a receiver that receives alternating current power wirelessly from a station (not shown) according to wireless power transmission.

The fuse 102 shown in FIG. 9 may be a safety device that protects a circuit downstream by automatically disconnected when a magnitude of input current provided from the input power source 101 reaches a limit value or more. The bridge diode 103 may be a component that acts as a rectifier to convert an alternating current voltage input through the fuse 102 into a DC voltage. Accordingly, the bridge diode 103 may also be referred to as a rectifier.

Because the PFC circuit 104 shown in FIG. 9 generates an output voltage $V_{dc}$ by boosting a direct current voltage $V_1$ transmitted from the bridge diode 103, the PFC circuit 104 may also be expressed as a boost converter. The output voltage $V_{dc}$ may be a voltage across both terminals of the capacitor 13 and may also be expressed as a DC link voltage. The PFC circuit 104 may secure operating performance of the load 105 even when a low voltage is applied from the input power source 101, while preventing damage to the components included in the electrical device 300 in a poor power supply region, by setting maximum DC link voltage information when a voltage of the input power source 101 is 110 $V_{ac}$ to be the same as maximum DC link voltage information when a voltage of the input power source 101 is 220 $V_{ac}$. Securing the operating performance of the load 105 may mean supplying power required to operate the load 105. For example, securing the operating performance of the load 105 may mean supplying, in the case in which the load 105 is a compressor motor of an outdoor unit of an air conditioner, power required to drive the compressor motor. The maximum DC link voltage information may also be referred to as a maximum DC link voltage level or a maximum DC link voltage value.

The first voltage sensor 301 may sense an input voltage $V_1$ of the PFC circuit 104. Sensing the input voltage $V_1$ of the PFC circuit 104 may be expressed as sensing input voltage information or an input voltage value of the PFC circuit 104. The first voltage sensor 301 may be configured with a resistor or a capacitor, although not limited thereto.

The second voltage sensor 302 may sense an output voltage $V_{dc}$ of the PFC circuit 104. Sensing the output voltage $V_{dc}$ of the PFC circuit 104 may be expressed as sensing output voltage information, an output voltage value, DC link voltage information, or a DC link voltage value of the PFC circuit 104. The second voltage sensor 302 may be configured with a resistor or a capacitor, although not limited thereto.

The processor 902 may read voltage information sensed by the first voltage sensor 301 and the second voltage sensor 302. The processor 902 may receive sensed voltage information from the first voltage sensor 301 and the second voltage sensor 302. The voltage information read from the first voltage sensor 301 may also be expressed as first voltage information. The first voltage information may also be expressed as input voltage information, an input voltage value, or an input voltage. The voltage information read from the second voltage sensor 302 may also be expressed as second voltage information. The second voltage information may also be expressed as an output voltage, output voltage information, an DC link voltage, or DC link voltage information.

The processor 902 may obtain input voltage information based on the first voltage information and the second voltage information. The processor 902 may compare the first voltage information with the second voltage information, and when the first voltage information is the same as the second voltage information, the processor 902 may obtain the same information as input voltage information. When the first voltage information is different from the second voltage information by comparing the first voltage information with the second voltage information, the processor 902 may obtain the first voltage information as input voltage information.

For example, when the first voltage information is 110 $V_{ac}$ (or 127 $V_{ac}$) and the second voltage information is 110 $V_{ac}$ (or 127 $V_{ac}$), the processor 902 may obtain 110 $V_{ac}$ (or 127 $V_{ac}$) as input voltage information. For example, when the first voltage information is 110 $V_{ac}$ (or 127 $V_{ac}$) and the second voltage information is 130 $V_{ac}$ (or 147 $V_{ac}$), the processor 902 may obtain 110 $V_{ac}$ (or 127 $V_{ac}$) as input voltage information. That the second voltage information is 130 $V_{ac}$ (or 147 $V_{ac}$) may be due to boosting by the PFC circuit 104. When the first voltage information is 220 $V_{ac}$ (or 230 $V_{ac}$) and the second voltage information is 220 $V_{ac}$ (or 230 $V_{ac}$), the processor 902 may obtain 220 $V_{ac}$ (or 230 $V_{ac}$) as input voltage information. For example, when the first voltage information is 220 $V_{ac}$ (or 230 $V_{ac}$) and the second voltage information is 235 $V_{ac}$ (or 245 $V_{ac}$), the processor 902 may obtain 220 $V_{ac}$ (or 230 $V_{ac}$) as input voltage information. That the second voltage information is 235 $V_{ac}$ (or 245 $V_{ac}$) may be due to boosting by the PFC circuit 104.

After the processor 902 obtains the input voltage information, the processor 902 may compare the obtained input voltage information with preset reference voltage information to determine whether the input voltage is a low voltage or a high voltage. The preset reference voltage information may be expressed as reference information for determining whether an input voltage is a low voltage or a high voltage based on a variation range of the input voltage. The preset reference voltage information may be stored in the processor 902 or the memory 1470 of FIG. 14 which will be described below. The memory 1470 may be included in the electrical device 900. In the case in which the reference voltage information is stored in the memory 1470, the processor 902 may read the reference voltage information from the memory 1470 and use the reference voltage information. For example, the preset reference voltage information may be set to 165 $V_{ac}$, although not limited thereto.

When the obtained input voltage information is 165 $V_{ac}$ or less, the processor 902 may determine the input voltage applied from the input power source 101 to be a low voltage. When the obtained input voltage information is greater than 165 $V_{ac}$, the processor 902 may determine the input voltage applied from the input power source 101 to be a high voltage. After the processor 902 determines whether the input voltage is a low voltage or a high voltage, the processor 902 may re-determine whether the input voltage is a low voltage or a high voltage.

To prevent a situation of continuing to monitor input voltage information when the input voltage information is re-determined, the processor 902 may apply hysteresis. For example, the processor 902 may prevent re-determination due to voltage fluctuations through hysteresis of about 30 $V_{ac}$ based on a previously determined voltage. For example, when input voltage information obtained after an input voltage applied from the input power source 101 is determined to be a low voltage of 110 $V_{ac}$ is 180 $V_{ac}$ or more, the processor 902 may determine an input voltage applied to the input power source 101 to be a high voltage of 220 $V_{ac}$. For example, when input voltage information obtained after the processor 902 determines that an input voltage applied from the input power source 101 is a high voltage of 220 $V_{ac}$ is 150 $V_{ac}$ or less, the processor 902 may determine an input voltage applied from the input power source 101 to be a low voltage of 110 $V_{ac}$.

After the processor 902 determines that an input voltage applied from the input power source 101 is a low voltage or a high voltage, the processor 902 may set a protection level of the PFC circuit 104 based on the determined input voltage. The protection level may include at least one or all of an overvoltage protection level, an undervoltage protection level, or an input current limit level, although not limited thereto.

For example, the processor 902 may set an overvoltage protection level and an undervoltage protection level when a determined input voltage is a low voltage to be lower than an overvoltage protection level and an undervoltage protection level when an input voltage is a high voltage. The overvoltage protection level may also be expressed as an overvoltage level, an overvoltage protection value, or an overvoltage value. The undervoltage protection level may also be expressed as an undervoltage level, an undervoltage protection value, or an undervoltage value. Also, the processor 303 may set an input current limit level when an input voltage is a low voltage to be higher than an input current limit level when an input voltage is a high voltage. The input current limit level may also be expressed as an input current limit value or an input current level.

For example, when an input voltage applied from the input power source 101 is a low voltage of 110 $V_{ac}$, the processor 902 may set an undervoltage protection level of the PFC circuit 104 to 65 $V_{ac}$, an overvoltage protection level of the PFC circuit 104 to 210 $V_{ac}$, and an input current limit level of the PFC circuit 104 to 30A, although not limited thereto. For example, when an input voltage applied from the input power source 101 is a high voltage of 220 $V_{ac}$, the processor 902 may set an undervoltage protection level of the PFC circuit 104 to 140 $V_{ac}$, an overvoltage protection level of the PFC circuit 104 to 270 $V_{ac}$, and an input current limit level of the PFC circuit 104 to 24A, although not limited thereto. As such, by setting, by the processor 902, an overvoltage protection level, an undervoltage protection level, or/and an input current limit level depending on an input voltage applied from the input power source 101, as described above, damage to the PFC circuit 104 and the components included in the electrical device 900 may be prevented.

Also, to secure the performance of the load 105, the processor 902 may control a boosting operation of the PFC circuit 104 such that a DC link maximum boost level of the PFC circuit 104 when an input voltage applied from the input power source 101 is a low voltage of 110 $V_{ac}$ is equal to a DC link maximum boost level when an input voltage applied from the input power source 101 is 220 $V_{ac}$. Securing the performance of the load 105 may mean supplying power required by the load 105.

Because the processor 902 controls a DC link maximum boost level of the PFC circuit 104 when an input voltage applied from the input power source 101 is a low voltage to be equal to a DC link maximum boost level of the PFC circuit 104 when an input voltage applied from the input power source 101 is a high voltage, a DC link voltage of the PFC circuit 104 may exceed a reference overvoltage protection level for a low voltage of 110 $V_{ac}$, which may result in generation of an overvoltage error. To prevent the generation of the overvoltage error, the processor 902 may control an operation of the switch controller 14 of the PFC circuit 104 such that, when a DC link voltage of the PFC circuit 104 is boosted according to a voltage command provided from the voltage command generator 304, an overvoltage protection level of 110 $V_{ac}$ increases together, as shown in FIG. 4. A maximum increase value of the overvoltage protection level may be limited to a reference overvoltage protection level for a high voltage of 220 $V_{ac}$ set based on specifications of the capacitor 13 or the switch 11, as shown in FIG. 4.

Also, the processor 902 may calculate a rising slope of a DC link voltage of the PFC circuit 104, and when the calculated rising slope of the DC link voltage is greater than a preset value (or level), the processor 902 may control an operation of the relay 901 to turn the relay 901 off, thereby limiting a level of inrush current that is applied to the bridge diode 103.

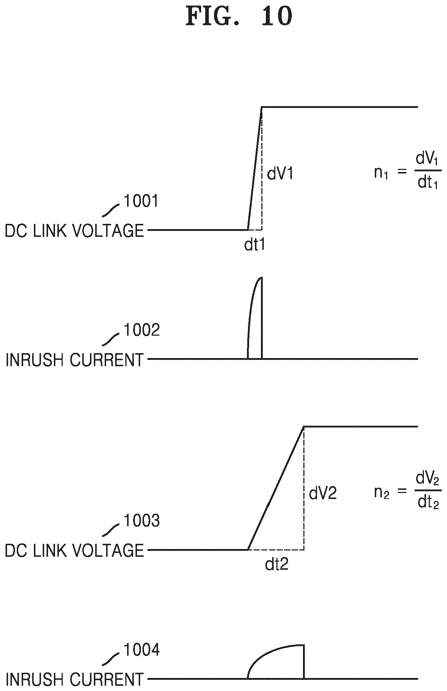

FIG. 10 is an example diagram showing relationship between inrush current and rising slopes of a DC link voltage of the PFC circuit 104 according to an embodiment of the disclosure. When a rising slope of a DC link voltage has a sharply increasing slope ($n_1(=dV_1/dt_1)$) as shown in 1001 of FIG. 10 while the capacitor 13 of the PFC circuit 104 is not charged, inrush current may be applied as a great value as shown in 1002 of FIG. 10. In contrast, when a rising slope of a DC link voltage of the PFC circuit 104 is a slope ($n_2(=dV_2/dt_2)$) that does not steeply increase as shown in 1003 of FIG. 10, inrush current may not increase significantly as shown in 1004 of FIG. 10 and have a value below specific current.

The processor 902 may control an off operation of the relay 901 to limit an inrush current level as shown in 1004 of FIG. 10.

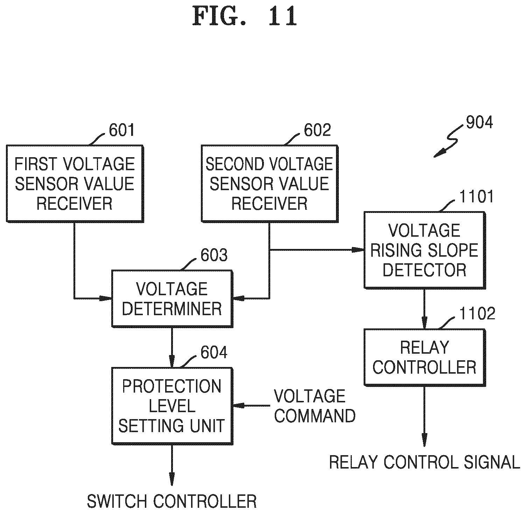

FIG. 11 is a configuration block diagram of the processor 902 shown in FIG. 9. Referring to FIG. 11, the processor 902 may include the first voltage sensor value receiver 601, the second voltage sensor value receiver 602, the voltage determiner 603, the protection level setting unit 604, a voltage rising slope detector 1101, and a relay controller 1102, although not limited thereto.

The first voltage sensor value receiver 601 may be configured to read an input voltage sensed by the first voltage sensor 301. The first voltage sensor value receiver 601 may be configured to receive an input voltage sensed by the first voltage sensor 301. A configuration of the first voltage sensor value receiver 601 may determine according to a configuration of the first voltage sensor 301. For example, the first voltage sensor value receiver 601 may determine a connection point to the first voltage sensor 301 depending on whether the first voltage sensor 301 is configured with a resistor or a capacitor.

The second voltage sensor value receiver 602 may be configured to read an input voltage sensed by the second voltage sensor 302. The second voltage sensor value receiver 602 may be configured to receive an input voltage sensed by the second voltage sensor 302. A configuration of the second voltage sensor value receiver 602 may determine according to a configuration of the second voltage sensor 302. For example, the second voltage sensor value receiver 602 may determine a connection point to the second voltage sensor 302 depending on whether the second voltage sensor 302 is configured with a resistor or a capacitor.

The voltage determiner 603 may obtain an input voltage of the electrical device 300 based on input voltage information of the PFC circuit 104 received by the first voltage sensor value receiver 601 and DC link voltage information of the PFC circuit 104 received by the second voltage sensor value receiver 602. After the input voltage of the electrical device 300 is obtained, the voltage determiner 603 may compare the obtained input voltage with preset reference voltage information to determine whether the input voltage of the electrical device 300 is a low voltage or a high voltage. The preset reference voltage has been mentioned with reference to FIG. 3. For example, the preset reference voltage may be 165 $V_{ac}$. The voltage determiner 603 may be expressed as a voltage judgement unit or a voltage check unit. A unit may be expressed as a processor.

The protection level setting unit 604 may set a protection level of the PFC circuit 104 according to a voltage determined by the voltage determiner 603. The protection level of the PFC circuit 104 may include at least one or all of an overvoltage protection level, an undervoltage protection level, or an input current limit level, although not limited thereto. The protection level of the PFC circuit 104 may be aimed to prevent damage to the components included in the electrical device 300 against inrush current that may be generated in a poor power supply environment.

The overvoltage protection level may be set based on a maximum voltage that the components included in the electrical device 300 can withstand. Particularly, when the input power source 101 is a low voltage, the overvoltage protection level may change based on a DC link boost command voltage according to an operation of the load 105. Accordingly, although the switch controller 14 of FIG. 1 is configured to control an operation of the switch 11 based on an input voltage of the PFC circuit 104, the switch controller 14 may be configured to receive a DC link boost command voltage through another side. The DC link boost command voltage may be based on a motor required voltage according to operating speed of a motor included in the load 105. The undervoltage protection level may be set to prevent damage to the components included in the electrical device 300 against inrush current. The input current limit level may be set to maintain a maximum of an output voltage $V_{dc}$ of the PFC circuit 104.

The overvoltage protection level, the undervoltage protection level, or/and the input current limit level may be set differently depending on whether power applied to the input power voltage 101 is a low voltage or a high voltage. The overvoltage protection level, the undervoltage protection level, or/and the input current limit level may be set in consideration of a voltage variation range per hour in a poor power supply region where rapid variations in voltage may occur while the electrical device 300 operates.

The protection level setting unit 604 may set a protection level of the PFC circuit 104 based on a voltage command generated according to a motor required voltage transmitted from the load 105, as described with reference to FIG. 3. The voltage command may be expressed as a DC link voltage command.

Because the protection level setting unit 604 actively changes a protection level of the PFC circuit 104 according to an input voltage applied from the input power source 101, the protection level setting unit 604 may also be expressed as a protection level changing unit.

The voltage rising slope detector 1101 may obtain a rising slope value of a DC link voltage by detecting a change per hour of a DC link voltage received from the second voltage sensor value receiver 602. The obtained rising slope value of the DC link voltage may be transmitted to the relay controller 1102. The relay controller 1102 may compare the received rising slope value of the DC link voltage with a preset reference level, and when the received rising slope value of the DC link voltage is determined to be greater than the reference level, the relay controller 1102 may output a control signal for turning the relay 901 off to the relay 901.

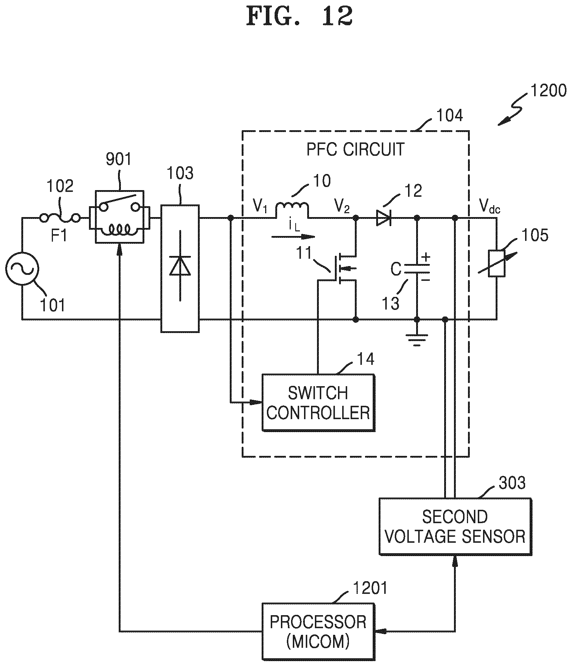

FIG. 12 is a configuration block diagram of the electrical device 1200 according to an embodiment of the disclosure. FIG. 12 is an example of an electrical device 1200 capable of preventing damage to elements against inrush current based on a slope of a DC link voltage added in FIG. 9.

The electrical device 120 shown in FIG. 12 may include the input power source 101, the fuse 102, the relay 901, the bridge diode 103, the PFC circuit 104, the load 105, the second voltage sensor 302, and the processor 1201, although not limited thereto. For example, the electrical device 1200 shown in FIG. 12 may be configured to further include the EMI filter 1411 mentioned in FIG. 14 which will be described below.

The input power source 101 may be an alternating current (AC) power source having a low voltage, a high voltage, or a voltage according to universal standards. For example, the low voltage may include 110 $V_{ac}$ $\pm$ 10% or 127 $V_{ac}$, although not limited thereto. 110 $V_{ac}$ mentioned below is an example of a low voltage mentioned in an embodiment of the present disclosure and may be replaced with a low voltage of another value. The high voltage may include 220 $V_{ac}$ $\pm$ 10% or 230 $V_{ac}$, although not limited thereto. 220 $V_{ac}$ mentioned below is an example of a high voltage mentioned in an embodiment of the present disclosure and may be replaced with a high voltage of another value. The voltage according to the universal standards may range from 85 $V_{ac}$ to 265 $V_{ac}$, although not limited thereto.

The input power source 101 may be an alternating current power source through a power line connected to a power outlet. The input power source 101 may be a receiver that receives alternating current power wirelessly from a station (not shown) according to wireless power transmission.

The fuse 102 shown in FIG. 12 may be a safety device that protects a circuit downstream by automatically disconnected when a magnitude of input current provided from the input power source 101 reaches a limit value or more. The bridge diode 103 may be a component that acts as a rectifier to convert an alternating current voltage input through the fuse 102 into a direct current voltage. Accordingly, the bridge diode 103 may also be referred to as a rectifier.

Because the PFC circuit 104 shown in FIG. 12 generates an output voltage $V_{dc}$ by boosting a DC voltage $V_1$ transmitted from the bridge diode 103, the PFC circuit 104 may also be referred to as a boost converter. The output voltage $V_{dc}$ may be a voltage across both terminals of the capacitor 13, and may also referred to as a DC link voltage. The PFC circuit 104 may secure operating performance of the load 105 even when a low voltage is applied from the input power source 101, while preventing damage to the components included in the electrical device 300, in a poor power supply region, by setting a maximum DC link voltage level when a voltage of the input power source 101 is 110 $V_{ac}$ to be the same as maximum DC link voltage information when a voltage of the input power source 101 is 220 $V_{ac}$. The maximum DC link voltage information may also be referred to as a maximum DC link voltage level or a maximum DC link voltage value.

The second voltage sensor 302 may sense an output voltage $V_{dc}$ of the PFC circuit 104. Sensing the output voltage $V_{dc}$ of the PFC circuit 104 may be expressed as sensing output voltage information, an output voltage value, DC link voltage information, or a DC link voltage value of the PFC circuit 104. The second voltage sensor 302 may be configured with a resistor or a capacitor, although not limited thereto.

The processor 1201 may read voltage information sensed by the second voltage sensor 302. The processor 1201 may receive sensed voltage information from the second voltage sensor 302. The voltage information read from the second voltage sensor 302 may also be expressed as second voltage information. The second voltage information may also be expressed as an output voltage, output voltage information, an DC link voltage, or DC link voltage information.

The processor 1201 may calculate a rising slope of a DC link voltage of the PFC circuit 104, read from the second voltage sensor 302, and when the calculated rising slope of the DC link voltage is greater than a preset value (or level), the processor 1201 may control an operation of the relay 901 to turn the relay 901 off, thereby limiting a level of inrush current that is applied to the bridge diode 103. Limiting the level of inrush current has been described above in regard to the voltage rising slope detector 1101 and the relay controller 1102 shown in FIG. 11.

The electrical device 1200 shown in FIG. 12 may include the relay 901, the PFC circuit 104 connected to the relay 901 to correct a power factor of the electrical device 1200, the second voltage sensor 303 that detects DC link voltage information of the PFC circuit 104, and the at least one processor 1201. The at least one processor 1201 may calculate a rising slope of a DC link voltage of the PFC circuit 104 based on DC link voltage information detected by the second voltage sensor. The at least one processor 1201 may be configured to control, when the calculated rising slope of the DC link voltage is greater than a preset value (or level), an operation of the relay 901 to turn the relay 901 off.

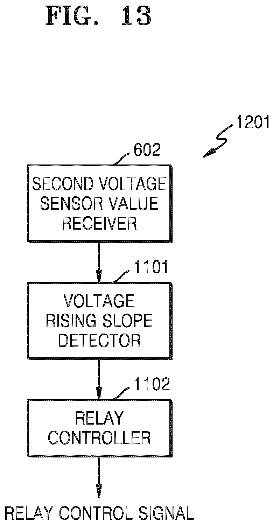

FIG. 13 is a configuration block diagram of the processor 1201 shown in FIG. 12. Referring to FIG. 13, the processor 1201 may include the second voltage sensor value receiver 602, the voltage rising slope detector 1101, and the relay controller 1102.

The second voltage sensor value receiver 602 may be configured to read an input voltage sensed by the second voltage sensor 302. The second voltage sensor value receiver 602 may be configured to receive an input voltage sensed by the second voltage sensor 302. A configuration of the second voltage sensor value receiver 602 may determine according to a configuration of the second voltage sensor 302. For example, the second voltage sensor value receiver 602 may determine a connection point to the second voltage sensor 302 depending on whether the second voltage sensor 302 is configured with a resistor or a capacitor.

The voltage rising slope detector 1101 may obtain a rising slope value of a DC link voltage by detecting a change per hour of a DC link voltage received from the second voltage sensor value receiver 602. The obtained rising slope value of the DC link voltage may be transmitted to the relay controller 1102. The relay controller 1102 may compare the received rising slope value of the DC link voltage with a preset reference level, and when the received rising slope value of the DC link voltage is determined to be greater than the reference level, the relay controller 1102 may output a control signal for turning the relay 901 off to the relay 901.

FIG. 14 is a configuration block diagram of an electrical device 1400 according to an embodiment of the present disclosure.

The electrical device 1400 shown in FIG. 14 may be configured to actively set a protection level of the PFC circuit 104 according to an input voltage and secure performance of the load 105, like the electrical device 300, 900, or 1200 shown in FIG. 3, 9, or 12. Securing the performance of the load 105 may mean supplying power required by the load 105.

As shown in FIG. 14, the electrical device 1400 according to an embodiment of the present disclosure may include a driver 1410, a processor 1420, a communication interface 1430, a sensor 1440, an output interface 1450, a user input interface 1460, a memory 1470, and the load 105. The components of the electrical device 1400 may not be essential. Another component may be added or some components may be omitted according to a design concept of a manufacturing company.

The driver 1410 shown in FIG. 14 may receive power from the input power source 101 or an external source (ES), and supply current to the load 105 according to a driving control signal from the processor 1420. The driver 1410 may include the EMI filter 1411, a rectifier circuit 1412, an inverter circuit 1413, the PFC circuit 104, and the relay 901, although not limited thereto.

The EMI filter 1411 may block high-frequency noise included in alternating current power supplied from the input power source 101 or the external source ES, and pass an alternating current voltage and alternating current of a preset frequency (for example, 50 Hz or 60 Hz). The fuse 102 and the relay 901 for blocking an overvoltage may be provided between the EMI filter 1411 and the external source ES. Alternating current power from which high-frequency noise has been removed by the EMI filter 1411 may be supplied to the rectifier circuit 1412.

The rectifier circuit 1412 may convert the alternating current power into direct current power. For example, the rectifier circuit 1412 may convert an alternating current voltage of which a magnitude and polarity (a positive voltage or a negative voltage) change according to a time, into a direct current voltage having a constant magnitude and polarity, and convert alternating current of which a magnitude and direction (positive current or negative current) change according to a time, into direct current having a constant magnitude. The rectifier circuit 1412 may include the bridge diode 103. For example, the rectifier circuit 1412 may include four diodes. The bridge diode 103 may convert an alternating current voltage of which a polarity changes according to a time, into a positive voltage having a constant polarity, and convert alternating current of which a direction changes according to a time, into positive current having a constant direction.

The inverter circuit 1413 may include a switching circuit that supplies current to the load 105 or prevents current from being supplied to the load 105. The switching circuit may include a first switch and a second switch. The first switch and the second switch may be connected in series between a plus line and a minus line output from the rectifier circuit 1412. The first switch and the second switch may be turned on or off according to a driving control signal from the processor 1420.

The inverter circuit 1413 may control current that is supplied to the load 105. For example, by turning on/off the first switch and the second switch included in the inverter circuit 1413, a magnitude and direction of current flowing to the load 105 may change. In this case, alternating current may be supplied to the load 105. According to a switching operation of the first switch and the second switch, sinusoidal alternating current may be supplied to the load 105. In addition, as switching cycles of the first switch and the second switch become longer (for example, as switching frequencies of the first switch and the second switch become smaller), current supplied to the load 105 may become larger or intensity of a magnetic field output to the load 105 may become greater. The inverter circuit 1413 of FIG. 14 may be required when alternating current is supplied to the load 105, and therefore, the inverter circuit 1413 may not be required in the electrical device 300, 900, or 1200 that supplies direct current to the load 105. Also, the inverter circuit 1413 of the electrical device 1400 according to an embodiment may be replaced with the PFC circuit 104 included in the electrical device 300, 900, or 1200.

An off operation of the relay 901 may be controlled by the processor 1420 based on a detection result of a rising slope of a DC link voltage, as described with reference to FIG. 9.

The processor 1420 may control overall operations of the electrical device 1400. The processor 1420 may execute programs stored in the memory 1470 to control the communication interface 1430, the sensor 1440, the output interface 1450, the user input interface 1460, the memory 1470, and the load 105.

According to an embodiment of the present disclosure, the electrical device 1400 may install an Artificial Intelligence (AI) processor therein. The AI pro-

cessor may be manufactured in the form of a dedicated hardware chip for AI, or may be manufactured as a part of an existing general-purpose processor (for example, central processing unit (CPU) or application processor) or a graphic dedicated processor (for example, graphic processing unit (GPU)) and installed in the electrical device 1400.

According to an embodiment of the disclosure, the processor 1420 may set an overvoltage protection level, an undervoltage protection level, or/and an input current limit level according to whether an input voltage of the PFC circuit 104 is a low voltage or a high voltage, control a maximum value of a DC link voltage, and control an off operation of the relay 901 based on a slope of the DC link voltage.

The processor 1420 may store, in the memory 2700, a reference voltage value used for determining whether an input voltage of the PFC circuit 104 is a low voltage or a high voltage and a reference value for determining whether a slope of a DC link voltage is a preset level or more, and read and use the reference voltage value or the reference value stored in the memory 2700.

The processor 1420 may include the communication interface 1430 to operate on an Internet of Things (IoT) network or a home network as necessary.

The communication interface 1430 may include a short-range wireless communication interface 1431 and a long-distance communication interface 1432. The short-range wireless communication interface 1431 may include a Bluetooth communication interface, a Bluetooth Low Energy (BLE) communication interface, a Near Field Communication (NFC) interface, a Wireless Local Access Network (WLAN: Wi-Fi) communication interface, a Zigbee communication interface, an Infrared Data Association (IrDA) communication interface, a Wi-Fi Direct (WFD) communication interface, a Ultra Wideband (UWB) communication interface, and an Ant+ communication interface, although not limited thereto. The long-distance communication interface 1432 may transmit and receive a wireless signal to/from at least one among a base station, an external terminal, or a server on a mobile communication network. Herein, the wireless signal may include a voice call signal, a video call signal or various formats of data according to transmission/reception of text/multimedia messages. The long-distance communication interface 1432 may include a 3Generation (3G) module, a 4Generation (4G) module, a 5Generation (4G) module, a Long-Term Evolution (LTE) module, a Narrowband Internet of Thing (NB-IoT) module, a Long Term Evolution for Machines (LTE-M) module, etc., although not limited thereto.

According to an embodiment of the disclosure, the electrical device 1400 may communicate with and transmit/receive data to/from an external server or another electrical device through the long-distance communication interface 1432.

The sensor 1440 may include an input voltage sensor 1441 and a DC link voltage sensor 1442, although not limited thereto. For example, the sensor 1440 may further include a current sensor. The current sensor may sense input current of the electrical device 1400. The current sensor may be positioned at various locations of a circuit of the electrical device 1400 to obtain current (mainly alternating current) information. The input voltage sensor 1441 may be used to sense voltage information of the input power source 101 of the electrical device 1400. The input voltage sensor 1441 may correspond to the first voltage sensor 301. The DC link voltage sensor 1442 may be used to sense a DC link voltage of the PFC circuit 104. The DC link voltage sensor 1442 may correspond to the second voltage sensor 302.

The output interface 1450 may be used to output an audio signal or a video signal, and include a display 1451 and a sound output device 1452.

According to an embodiment of the disclosure, the electrical device 1400 may display information related to the electrical device 1400 through the display 1451. For example, the electrical device 1400 may display, on the display 1451, power factor information of the electrical device 1400, a current input voltage, and information about whether a protection level of the PFC circuit 104 has been set.

In the case in which the display 1451 and a touch pad form a layer structure to be configured as a touch screen, the display 1451 may be used as an input device, as well as an output device. The display 1451 may include at least one of a liquid crystal display (LCD), a thin film transistor-liquid crystal display (TFT-LCD), a light-emitting diode (LED) display, an organic light-emitting diode (OLED) display, a flexible display, a 3dimensional (3D) display, or an electrophoretic display. Also, according to an implementation type of the electrical device 1400, the electrical device 1400 may include two or more displays 1451.

The sound output device 1452 may output audio data that is received from the communication interface 1430 or stored in the memory 1470. Also, the sound output device 1452 may output a sound signal related to a function that is performed by the electrical device 1400. The sound output device 1452 may include a speaker, a buzzer, etc.

According to an embodiment of the disclosure, the output interface 1450 may output at least one among power factor information, input voltage information, information about whether a protection level for the PFC circuit 104 has been set, or information indicating that a protection level is changing, through the display 1451.

The user input interface 1460 may be used to receive an input from a user. The user input interface 1460 may include at least one among a key pad, a dome switch, a touch pad (a capacitive type, a resistive type, an infrared beam type, a surface acoustic wave conduction type, an integral strain gauge type, a piezoelectric effect type, or the like), a jog wheel, or a jog switch, although not limited thereto.

The user input interface 1460 may include a voice recognition module. For example, the electrical device 1400 may receive a voice signal as an analog signal through a microphone, and convert a voice part into a computer-readable text through an Automatic Speech Recognition (ASR) model. The electrical device 1400 may obtain a user's utterance intention by interpreting the converted text by using a Natural Language Understanding (NLU) model. Herein, the ASR model or the NLU model may be an AI model. The AI model may be processed by an AI-dedicated processor designed with a hardware structure specialized for processing AI models. The AI model may be created through training. Herein, creating through training may mean creating a predefined operation rule or artificial intelligent model set to perform a desired characteristic (or a purpose) by training a basic AI model with a plurality of pieces of training data through a training algorithm. The AI model may be configured with a plurality of neural network layers. Each of the plurality of neural network layers may have a plurality of weight values and perform a neural network operation through computation between a computation result of a previous layer and the plurality of weight values.

Linguistic understanding is technology of recognizing and applying/processing human language/-characters, and includes Natural Language Processing, Machine Translation, Dialog System, Question Answering, and Speech Recognition/Synthesis.

The memory 1470 may store a program for processing and controlling by the processor 1420, and may also store input/output data (for example, power factor information of the electrical device 1400, input voltage information, information related to protection level settings, etc.). The memory 1470 may also store an AI model.

The memory 220 may include at least one type of storage medium among a flash memory type, a hard disk type, a multimedia card micro type, card type memory (for example, Secure Digital (SD) memory or eXtreme Digital (XD) memory), Random Access Memory (RAM), Static Random Access Memory (SRAM), Read-Only Memory (ROM), Electrically Erasable Programmable Read-Only Memory (EEPROM), and Programmable Read-Only Memory (PROM), magnetic memory, a magnetic disk, or an optical disk. Additionally, the control device 1400 may operate a web storage or cloud server that performs a storage function on the Internet.

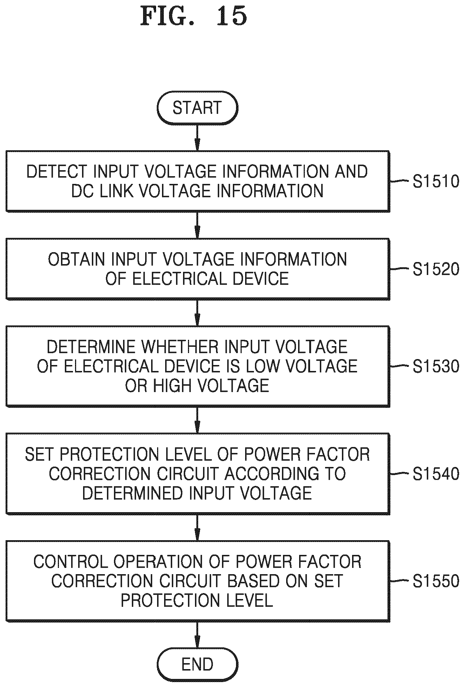

FIG. 15 is a flowchart illustrating operations of an electrical device according to an embodiment of the present disclosure. FIG. 15 is an example of controlling an operation of the PFC circuit 104 by determining whether an input voltage applied from the input power source 101 is a low voltage or a high voltage based on an input voltage and a DC link voltage of the PFC circuit 104 and setting a protection level of the PFC circuit 104 according to the determined voltage, and operations of FIG. 15 may be performed by the electrical device 300 of FIG. 3, the electrical device 900 of FIG. 9, and the electrical device 1400 of FIG. 14. Hereinafter, for convenience of description, the operations of FIG. 15 are described as being performed by the electrical device 300 of FIG. 3, but it should be interpreted that the electrical device 1400 shown in FIGS. 9 and 14 also performs the operations of FIG. 15.

In operation S1510, the processor 303 of the electrical device 300 may detect input voltage information of the PFC circuit 104 from the first voltage sensor 301 and detect DC link voltage information of the PFC circuit 104 from the second voltage sensor 302. Detecting the input voltage information from the first voltage sensor 301 may also be expressed as reading or receiving an input voltage from the first voltage sensor 301 by the processor 303. Detecting the DC link voltage information from the second voltage sensor 302 may also be expressed as reading or receiving a DC link voltage from the second voltage sensor 302 by the processor 303.

In operation S1520, the processor 303 may obtain an input voltage of the electrical device 300. The processor 303 may obtain the input voltage based on the detected input voltage information and the DC link voltage information. According to the detected input voltage information being different from the DC link voltage information, the detected input voltage information may be obtained as input voltage information. When the detected input voltage information is the same as the DC link voltage information, the same voltage information may be obtained as input voltage information.

In operation S1530, the processor 303 may determine whether the input voltage of the electrical device 300 is a low voltage or a high voltage. The processor 303 may determine a low voltage or a high voltage based on a preset reference voltage (for example, 165 $V_{ac}$). For example, when the detected input voltage information is lower than or equal to the preset reference voltage, the processor 303 may determine a low voltage, and, when the detected input voltage information is higher than the preset reference voltage, the processor 303 may determine a high voltage. Also, the processor 303 may re-determine whether the input voltage is a low voltage or a high voltage by applying hysteresis, as described with reference to FIG. 3.

In operation S1540, the processor 303 may set a protection level of the PFC circuit 104 according to the determined input voltage. The protection level may include an overvoltage protection level, an undervoltage protection level, or/and an input current limit level, although not limited thereto. An overvoltage protection level, an undervoltage protection level, or/and an input current limit level may be set actively according to an input voltage, as described with reference to FIG. 3. Also, the processor 330 may control an operation of the PFC circuit 104 such that a DC link maximum boost level of the PFC circuit 104 when the determined input voltage is a low voltage is equal to a DC link maximum boost level when the input voltage is a high voltage. Also, when the determined voltage is a low voltage, the processor 330 may perform a control of increasing an overvoltage protection level together with the DC link voltage of the PFC circuit 104 in response to a voltage command based on an operation of the load 105 included in the electrical device 900. In operation S1540, the processor 303 may set an overvoltage protection level and an undervoltage protection level of the PFC circuit 104 according to the determined input voltage, as described with reference to FIG. 3. In operation S1540, the processor 303 may set an input current limit level of the PFC circuit 104 according to the determined input voltage, as described with reference to FIG. 3. In operation S1540, the processor 303 may set an overvoltage protection level and an input current limit level of the PFC circuit 104 according to the determined input voltage, as described with reference to FIG. 3. In operation S1540, the processor 303 may set an undervoltage protection level and an input current limit level of the PFC circuit 104 according to the determined input voltage, as described with reference to FIG. 3.

In operation S1550, the processor 303 may control an operation of the PFC circuit 104, such as controlling a turn-on or turn-off cycle of the switch 11 of the PFC circuit 104, based on the set protection level. Controlling the turn-on or turn-off cycle of the switch 11 may include changing a cycle of the switch 11. Also, when the determined input voltage is a low voltage, the processor 303 may control an operation of the PFC circuit 104 to start boosting the DC link voltage at a lower voltage than when the input voltage is a high voltage.

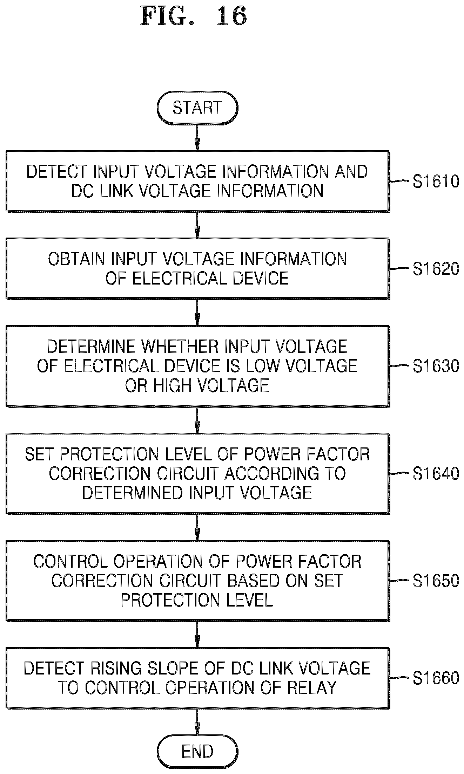

FIG. 16 is a flowchart illustrating operations of an electrical device according to an embodiment of the present disclosure. FIG. 16 is an example in which an operation of controlling a relay off operation based on a slope of a DC link voltage mentioned with reference FIG. 9 is added to the operation flowchart of FIG. 15. Therefore, the following description is based on the electrical device 900 shown in FIG. 9. However, the following operations may also be performed by the electrical device 1400 of FIG. 14.

In operation S1610, the processor 902 of the electric device 900 may detect input voltage information of the PFC circuit 104 from the first voltage sensor 301 and detect DC link voltage information of the PFC circuit 104 from the second voltage sensor 302. Detecting input voltage information from the first voltage sensor 301 may also be expressed as reading or receiving an input voltage from the first voltage sensor 301 by the processor 303. Detecting DC link voltage information from the second voltage sensor 302 may also be expressed as reading or receiving a DC link voltage from the second voltage sensor 302 by the processor 902.

In operation S1620, the processor 902 may obtain an input voltage of the electrical device 900. The processor 902 may obtain the input voltage based on the detected input voltage information and the DC link voltage information. According to the detected input voltage information being different from the DC link voltage information, the processor 902 may obtain the detected input voltage information as input voltage information. According to the detected input voltage information being the same as the DC link voltage information, the processor 902 may obtain the same voltage information as input voltage information.

In operation S1630, the processor 902 may determine whether the input voltage of the electrical device 900 is a low voltage or a high voltage. The processor 902 may determine a low voltage or a high voltage by using a preset reference voltage (for example, 165 $V_{ac}$). For example, according to the detected input voltage information being lower than or equal to the preset reference voltage, the processor 902 may determine a low voltage, and, according to the detected input voltage information being higher than the preset reference voltage, the processor 902 may determine a high voltage. Also, the processor 902 may re-determine whether the input voltage is a low voltage or a high voltage by applying hysteresis, as described with reference to FIG. 3.

In operation S1640, the processor 902 may set a protection level of the PFC circuit 104 according to the determined input voltage. The protection level may include an overvoltage protection level, an undervoltage protection level, or/and an input current limit level, although not limited thereto. An overvoltage protection level, an undervoltage protection level, or/and an input current limit level may be set actively according to the input voltage, as described with reference to FIG. 3. Also, the processor 330 may control an operation of the PFC circuit 104 such that a DC link maximum boost level of the PFC circuit 104 when the determined input voltage is a low voltage is equal to a DC link maximum boost level when the input voltage is a high voltage. Also, according to the determined voltage being a low voltage, the processor 902 may perform a control of increasing an overvoltage protection level together with the DC link voltage of the PFC circuit 104 in response to a voltage command based on an operation of the load 105 included in the electrical device 900. In operation S1640, the processor 902 may set an overvoltage protection level and an undervoltage protection level of the PFC circuit 104 according to the determined input voltage, as described with reference to FIG. 3. In operation S1640, the processor 902 may set an input current limit level of the PFC circuit 104 according to the determined input voltage, as described with reference to FIG. 3. In operation S1640, the processor 902 may set an overvoltage protection level and an input current limit level of the PFC circuit 104 according to the determined input voltage, as described with reference to FIG. 3. In operation S1640, the processor 902 may set an undervoltage protection level and an input current limit level of the PFC circuit 104 according to the determined input voltage, as described with reference to FIG. 3.

In operation S1650, the processor 902 may control an operation of the PFC circuit 104, such as controlling a turn-on or turn-off cycle of the switch 11 of the PFC circuit 104, based on the set protection level. Also, when the determined input voltage is a low voltage, the processor 902 may control an operation of the PFC circuit 104 to start boosting the DC link voltage at a lower voltage than when the input voltage is a high voltage. Controlling the turn-on or turn-off cycle of the switch 11 may mean controlling an operation cycle of the switch 11. Controlling the operating cycle of the switch 11 may include changing the operating cycle of the switch 11.

In operation S1660, the processor 902 may detect a rising slope of a DC link voltage of the PFC circuit 104, and according to the detected rising slope of the DC link voltage being greater than a preset value, the processor 902 may control an operation of the relay 901 to turn the relay 901 off. The preset value may be read from the memory 1470 or may be a value stored in the processor 902.

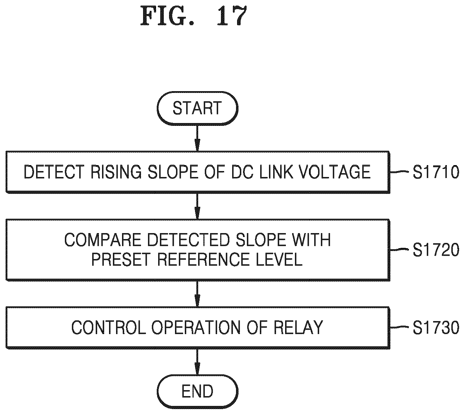

FIG. 17 is a flowchart illustrating operations of an electrical device according to an embodiment of the present disclosure. FIG. 17 is an example for preventing damage to components of the electrical device 1200 against inrush current by controlling an operation of a relay based on a slope of a DC link voltage of the PFC circuit 104, shown in FIG. 12.

In operation S1710, the processor 1201 of the electrical device 1200 may detect a rising slope of a DC link voltage of the PFC circuit 104, as shown in FIG. 10. In operation S1720, the processor 1201 of the electrical device 1200 may compare the detected rising slope of the DC link voltage with a preset reference level. In operation S1730, the processor 1201 may control an operation of the relay 901 based on a result compared in operation S1720. For example, according to the rising slope of the DC link voltage detected in operation S1720 being greater than or equal to the preset reference level, the processor 1201 may control the relay to turn the relay off, in operation S1730. According to the rising slope of the DC link voltage detected in operation S1720 being smaller than the preset reference level, the processor 1201 may control the relay to maintain the relay in a turned-on state, in operation S1730.

A method of controlling the electrical device 1200 including the power factor correction circuit 104 based on the flowchart shown in FIG. 17 may include detecting input voltage information of the power factor correction circuit 104 by the at least one processor 1201. The method of controlling the electrical device 1200 including the power factor correction circuit 104 based on the flowchart shown in FIG. 17 may include detecting DC link voltage information of the power factor correction circuit 104 by the at least one processor 1201. The processor 1201 may detect the DC link voltage information of the power factor correction circuit 104 from the second voltage sensor 302. The method of controlling the electrical device 1200 including the power factor correction circuit 104 based on the flowchart shown in FIG. 17 may include calculating, by the at least one processor 1201, a rising slope of a DC link voltage of the PFC circuit 104 based on the detected DC link voltage information. The method of controlling the electrical device 1200 including the power factor correction circuit 104 based on the flowchart shown in FIG. 17 may include controlling an operation of the relay 901 to turn the relay 901 off when the rising slope of the DC link voltage calculated by the at least one processor 1201 is greater than a preset value (or level).

The above-described electrical device 100, 300, 900, 1200, or 1400 may also be expressed as an electrical device according to an embodiment of the present disclosure.

As described above, by setting a protection level of the PFC circuit 104 according to an input voltage applied from the input power source 101, and controlling increases of an overvoltage protection level and a DC link voltage of the PFC circuit 104 according to a voltage command based on a motor required voltage by the load 105, it may be possible to supply stable power even in a poor power supply environment where a plurality of voltages are used, without a component such as a transformer that changes an input voltage, and to secure performance of the load.

An electrical device 100, 300, 900, 1200, or 1400 according to an embodiment of the present disclosure may include a power factor correction circuit 104 configured to correct a power factor of the electrical device 100, 300, 900, 1200, or 1400, a first voltage sensor 301 configured to detect input voltage information of the power factor correction circuit 104, a second voltage sensor 302 configured to detect DC link voltage information of the power factor correction circuit 104, and at least one processor 303, 902, 1201, or 1420 configured to obtain input voltage information of the electrical device 100, 300, 900, 1200, or 1400 based on the input voltage information detected by the first voltage sensor 301 and the DC link voltage information detected by the second voltage sensor 302, compare the obtained input voltage information with preset reference voltage information to determine whether an input voltage of the electrical device 100, 300, 900, 1200, or 1400 is a low voltage or a high voltage, set a protection level of the power factor correction circuit 104 according to the determined input voltage, and control an operating cycle of a switch 11 included in the power factor correction circuit 104 based on the set protection level.

The protection level of the power factor correction circuit 104 according to an embodiment of the present disclosure may include at least one of an overvoltage protection level, an undervoltage protection level, or an input current limit level.

Upon the setting of the protection level of the power factor correction circuit 104 according to an embodiment of the present disclosure, the at least one processor 303, 902, 1201, or 1420 may be configured to set, when the determined input voltage is a low voltage, the overvoltage protection level and the undervoltage protection level to be lower than an overvoltage protection level and an undervoltage protection level that are set when the input voltage is a high voltage, and set the input current limit level to be higher than an input current limit level that is set when the input voltage is a high voltage.

Upon the setting of the protection level of the power factor correction circuit 104 according to an embodiment of the present disclosure, the at least one processor 303, 902, 1201, or 1420 may be configured to set, when the determined input voltage is a low voltage, the overvoltage protection level and the undervoltage protection level to be lower than an overvoltage protection level and an undervoltage protection level that are set when the input voltage is a high voltage.

Upon the setting of the protection level of the power factor correction circuit 104 according to an embodiment of the present disclosure, the at least one processor 303, 902, 1201, or 1420 may be configured to set, when the determined input voltage is a low voltage, the input current limit level to be higher than an input current limit level that is set when the input voltage is a high voltage.

The at least one processor 303, 902, 1201, or 1420 according to an embodiment of the present disclosure may be configured to control, when the determined input voltage is a low voltage, an operation of the power factor correction circuit 104 such that a DC link maximum boost level of the power factor correction circuit 104 is equal to a DC link maximum boost level when the input voltage is a high voltage.

The electrical device 100, 300, 900, 1200, or 1400 according to an embodiment of the present disclosure may include a load 105, and the at least one processor 303, 902, 1201, or 1420 may be configured to increase, when the determined input voltage is a low voltage, the overvoltage protection level together with a DC link voltage of the power factor correction circuit 104 in response to a voltage command based on an operation of the load 105.

The at least one processor 303, 902, 1201, or 1420 according to an embodiment of the present disclosure may be configured to control, when the determined input voltage is a low voltage, an operation of the power factor correction circuit 104 to start boosting the DC link voltage at a lower voltage than when the input voltage of the electrical device 100, 300, 900, 1200, or 1400 is a high voltage.

The electrical device 100, 300, 900, 1200, or 1400 according to an embodiment of the present disclosure may include a relay 901 in front of the power factor correction circuit 104, and the at least one processor 303, 902, 1201, or 1420 may be configured to detect a rising slope of the DC link voltage, and control, according to the detected rising slope of the DC link voltage being greater than or equal to a preset reference value, an operation of the relay 901 to turn the relay 901 off.

A method of controlling an electrical device 100, 300, 900, 1200, or 1400 including a power factor correction circuit 104 according to an embodiment of the present disclosure may include detecting input voltage information of the power factor correction circuit 104 by at least one processor 303, 902, 1201, or 1420 of the electrical device 100, 300, 900, 1200, or 1400, detecting DC link voltage information of the power factor correction circuit 104 by the at least one processor 303, 902, 1201, or 1420, obtaining, by the at least one processor 303, 902, 1201, or 1420, input voltage information of the electrical device 100, 300, 900, 1200, or 1400 based on the input voltage information and the detected DC link voltage information, comparing, by the at least one processor 303, 902, 1201, or 1420, the obtained input voltage information with preset reference voltage information to determine whether an input voltage of the electrical device 100, 300, 900, 1200, or 1400 is a low voltage or a high voltage, setting, by the at least one processor 303, 902, 1201, or 1420, a protection level of the power factor correction circuit 104 according to the determined input voltage, and controlling an operating cycle of a switch 11 included in the power factor correction circuit 104 based on the set protection level.

The setting of the protection level of the power factor correction circuit 104 according to an embodiment of the present disclosure may include setting, by the at least one processor 303, 902, 1201, or 1420, when the determined input voltage is a low voltage, an overvoltage protection level of the power factor correction circuit 104 and an undervoltage protection level of the power factor correction circuit 104 to be lower than an overvoltage protection level and an undervoltage protection level that are set when the input voltage is a high voltage, and setting an input current limit level of the power factor correction circuit 104 to be higher than an input current limit level that is set when the input voltage is a high voltage.

The setting of the protection level of the power factor correction circuit 104 according to an embodiment of the present disclosure may include setting, by the at least one processor 303, 902, 1201, or 1420, when the determined input voltage is a low voltage, an overvoltage protection level of the power factor correction circuit 104 and an undervoltage protection level of the power factor correction circuit 104 to be lower than an overvoltage protection level and an undervoltage protection level that are set when the input voltage is a high voltage.

The setting of the protection level of the power factor correction circuit 104 according to an embodiment of the present disclosure may include setting, by the at least one processor 303, 902, 1201, or 1420, when the determined input voltage is a low voltage, an input current limit level of the power factor correction circuit 104 to be higher than an input current limit level that is set when the input voltage is a high voltage.

The method according to an embodiment of the present disclosure may include controlling, by the at least one processor 303, 902, 1201, or 1420, when the determined input voltage is a low voltage, an operation of the power factor correction circuit 104 such that a DC link maximum boost level of the power factor correction circuit 104 is equal to a DC link maximum boost level when the input voltage is a high voltage.

The setting of the protection level of the power factor correction circuit 104 according to an embodiment of the present disclosure may include performing control of increasing, when the determined input voltage is a low voltage, an overvoltage protection level together with a DC link voltage of the power factor correction circuit 104 in response to a voltage command based on an operation of a load 105 included in the electrical device 100, 300, 900, 1200, or 1400.

The method according to an embodiment of the present disclosure may include controlling, when the determined input voltage is a low voltage, an operation of the power factor correction circuit 104 to start boosting a DC link voltage at a lower voltage than when an input voltage of the electrical device 100, 300, 900, 1200, or 1400 is a high voltage.

The method according to an embodiment of the present disclosure may include detecting a rising slope of the DC link voltage of the power factor correction circuit 104, and turning off a relay 901 positioned in front of the power factor correction circuit 104 according to the detected rising slope of the DC link voltage being greater than or equal to a preset reference value.

A machine-readable storage medium may be provided in the form of a non-transitory storage medium, wherein the term 'non-transitory' simply means that the storage medium is a tangible device, and does not include a signal (e.g., an electromagnetic wave), but this term does not differentiate between where data is semi-permanently stored in the storage medium and where the data is temporarily stored in the storage medium. For example, a 'non-transitory storage medium' may include a buffer in which data is temporarily stored.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloadable or uploadable) online via an application store or between two user devices (e.g., smart phones) directly. When distributed online, at least part of the computer program product (e.g., a downloadable app) may be temporarily generated or at least temporarily stored in the machine-readable storage medium, such as a memory of the manufacturer's server, a server of the application store, or a relay server.

**Claims**

1. An electrical device 100, 300, 900, 1200, or 1400 comprising:

a power factor correction circuit 104 configured to correct a power factor of the electrical device 100, 300, 900, 1200, or 1400;

a first voltage sensor 301 configured to detect input voltage information of the power factor correction circuit 104;

a second voltage sensor 302 configured to detect DC link voltage information of the power factor correction circuit 104; and

at least one processor 303, 902, 1201, or 1420 configured to

obtain input voltage information of the electrical device 100, 300, 900, 1200, or 1400 based on the input voltage information detected by the first voltage sensor 301 and the DC link voltage information detected by the second voltage sensor 302,

compare the obtained input voltage information with preset reference voltage information so as to determine whether an input voltage of the electrical device 100, 300, 900, 1200, or 1400 is a low voltage or a high voltage,

set a protection level of the power factor correction circuit 104 according to the determined input voltage, and

control an operating cycle of a switch 11 included in the power factor correction circuit 104 based on the set protection level.

2. The electrical device of claim 1, wherein the protection level of the power factor correction circuit 104 includes at least one of an overvoltage protection level, an undervoltage protection level, or an input current limit level.

3. The electrical device of claim 2, wherein, upon the setting of the protection level of the power factor correction circuit 104,

the at least one processor 303, 902, 1201, or 1420 is configured to set, when the determined input voltage is a low voltage, the overvoltage protection level and the undervoltage protection level to be lower than an overvoltage protection level and an undervoltage protection level that are set when the input voltage is a high voltage, and set the input current limit level to be higher than an input current limit level that is set when the input voltage is a high voltage.

4. The electrical device of claim 2, wherein, upon the setting of the protection level of the power factor correction circuit 104,

the at least one processor 303, 902, 1201, or 1420 is configured to set, when the determined input voltage is a low voltage, the overvoltage protection level and the undervoltage protection level to be lower than an overvoltage protection level and an undervoltage protection level that are set when the input voltage is a high voltage.

5. The electrical device of claim 2, wherein, upon the setting of the protection level of the power factor correction circuit 104,
the at least one processor 303, 902, 1201, or 1420 is configured to set, when the determined input voltage is a low voltage, the input current limit level to be higher than an input current limit level that is set when the input voltage is a high voltage.

6. The electrical device of any one of claims 1 to 5, wherein the at least one processor 303, 902, 1201, or 1420 is configured to control, when the determined input voltage is a low voltage, an operation of the power factor correction circuit 104 such that a DC link maximum boost level of the power factor correction circuit 104 is equal to a DC link maximum boost level when the input voltage is a high voltage.

7. The electrical device of claim 6, the electrical device 100, 300, 900, 1200, or 1400 comprising a load 105, wherein the at least one processor 303, 902, 1201, or 1420 is configured to increase, when the determined input voltage is a low voltage, the overvoltage protection level together with a DC link voltage of the power factor correction circuit 104 in response to a voltage command based on an operation of the load 105.

8. The electrical device of any one of claims 1 to 7, wherein the at least one processor 303, 902, 1201, or 1420 is configured to control, when the determined input voltage is a low voltage, an operation of the power factor correction circuit 104 to start boosting the DC link voltage at a lower voltage than when the input voltage of the electrical device 100, 300, 900, 1200, or 1400 is a high voltage.

9. The electrical device of any one of claims 1 to 8, the electrical device 100, 300, 900, 1200, or 1400 comprising a relay 901 in front of the power factor correction circuit 104,
wherein the at least one processor 303, 902, 1201, or 1420 is configured to detect a rising slope of the DC link voltage, and control, according to the detected rising slope of the DC link voltage being greater than or equal to a preset reference value, an operation of the relay 901 to turn the relay 901 off.

10. A method of controlling an electrical device 100, 300, 900, 1200, or 1400 including a power factor correction circuit 104, the method comprising:

detecting input voltage information of the power factor correction circuit 104 by at least one processor 303, 902, 1201, or 1420 of the electrical device 100, 300, 900, 1200, or 1400;
detecting DC link voltage information of the power factor correction circuit 104 by the at least one processor 303, 902, 1201, or 1420;
obtaining, by the at least one processor 303, 902, 1201, or 1420, input voltage information of the electrical device 100, 300, 900, 1200, or 1400 based on the input voltage information and the detected DC link voltage information;
comparing, by the at least one processor 303, 902, 1201, or 1420, the obtained input voltage information with preset reference voltage information so as to determine whether an input voltage of the electrical device 100, 300, 900, 1200, or 1400 is a low voltage or a high voltage;
setting, by the at least one processor 303, 902, 1201, or 1420, a protection level of the power factor correction circuit 104 according to the determined input voltage; and
controlling an operating cycle of a switch 11 included in the power factor correction circuit 104 based on the set protection level.

11. The method of claim 10, wherein the setting of the protection level of the power factor correction circuit 104 comprises
setting, by the at least one processor 303, 902, 1201, or 1420, when the determined input voltage is a low voltage, an overvoltage protection level of the power factor correction circuit 104 and an undervoltage protection level of the power factor correction circuit 104 to be lower than an overvoltage protection level and an undervoltage protection level that are set when the input voltage is a high voltage, and setting an input current limit level of the power factor correction circuit 104 to be higher than an input current limit level that is set when the input voltage is a high voltage.

12. The method of claim 10, wherein the setting of the protection level of the power factor correction circuit 104 comprises
setting, by the at least one processor 303, 902, 1201, or 1420, when the determined input voltage is a low voltage, an overvoltage protection level of the power factor correction circuit 104 and an undervoltage protection level of the power factor correction circuit 104 to be lower than an overvoltage protection level and an undervoltage protection level that are set when the input voltage is a high voltage.

13. The method of claim 10, wherein the setting of the protection level of the power factor correction circuit 104 comprises
setting, by the at least one processor 303, 902, 1201, or 1420, when the determined input voltage is a low voltage, an input current limit level of the power factor correction circuit 104 to be higher than an input current limit level that is set when the input voltage is a high voltage.

**14.** The method of any one of claims 10 to 13, comprising controlling, by the at least one processor 303, 902, 1201, or 1420, when the determined input voltage is a low voltage, an operation of the power factor correction circuit 104 such that a DC link maximum boost level of the power factor correction circuit 104 is equal to a DC link maximum boost level when the input voltage is a high voltage.

**15.** The method of claim 14, wherein the setting of the protection level of the power factor correction circuit 104 comprises performing control of increasing, when the determined input voltage is a low voltage, an overvoltage protection level together with a DC link voltage of the power factor correction circuit 104 in response to a voltage command based on an operation of a load 105 included in the electrical device 100, 300, 900, 1200, or 1400, the method comprises controlling, when the determined input voltage is a low voltage, an operation of the power factor correction circuit 104 to start boosting a DC link voltage at a lower voltage than when an input voltage of the electrical device 100, 300, 900, 1200, or 1400 is a high voltage, and
the method comprises:

detecting a rising slope of the DC link voltage of the power factor correction circuit 104; and
turning off a relay 901 positioned in front of the power factor correction circuit 104 according to the detected rising slope of the DC link voltage being greater than or equal to a preset reference value.

# FIG. 1

## FIG. 2

PFC OUTPUT VOLTAGE
(DC LINK VOLTAGE)
INPUT ALTERNATING
CURRENT VOLTAGE

INPUT ALTERNATING
CURRENT

GENERATION OF INRUSH CURRENT

# FIG. 3

FIG. 4

REFERENCE OVERVOLTAGE
PROTECTION LEVEL FOR 220 $V_{ac}$ / 401

REFERENCE OVERVOLTAGE
PROTECTION LEVEL FOR 110 $V_{ac}$ / 402

DC LINK VOLTAGE LEVEL / 403

START BOOSTING DC LINK VOLTAGE

404

# FIG. 5

501
DC LINK VOLTAGE
LEVEL FOR 220 V$_{ac}$

DC LINK VOLTAGE
LEVEL FOR 110 V$_{ac}$

502

110 V$_{ac}$
START
BOOSTING

503

220 V$_{ac}$
START
BOOSTING

504

# FIG. 6

```
                                                          303

        601                               602
┌─────────────────────┐        ┌─────────────────────┐
│       FIRST         │        │      SECOND         │
│  VOLTAGE SENSOR     │        │  VOLTAGE SENSOR     │
│  VALUE RECEIVER     │        │  VALUE RECEIVER     │
└─────────────────────┘        └─────────────────────┘
          │                               │
          │          603                  │
          │    ┌─────────────┐            │
          └───▶│   VOLTAGE   │◀───────────┘
               │  DETERMINER │
               └─────────────┘
                      │
                      │       604
                      ▼
                ┌─────────────┐
   SWITCH       │ PROTECTION  │   VOLTAGE
  CONTROLLER ◀──│    LEVEL    │◀── COMMAND
               │ SETTING UNIT│
               └─────────────┘
```

# FIG. 7

POWER ON — S701

↓

SENSE VOLTAGE — S702

↓

S703
INPUT & DC LINK VOLTAGE ARE 110 $V_{ac}$ OR 127 $V_{ac}$? — NO →

S706
INPUT & DC LINK VOLTAGE ARE 220 $V_{ac}$ OR 230 $V_{ac}$? — NO →

S708
INPUT VOLTAGE IS 220 $V_{ac}$ OR 230 $V_{ac}$? — YES

S703: YES ↓

S706: YES ↓

S708: NO

S704
SET OVERVOLTAGE PROTECTION LEVEL, UNDERVOLTAGE PROTECTION LEVEL, OR/AND INPUT CURRENT LIMIT LEVEL OF 110 $V_{ac}$ OR 127 $V_{ac}$

S707
SET OVERVOLTAGE PROTECTION LEVEL, UNDERVOLTAGE PROTECTION LEVEL, OR/AND INPUT CURRENT LIMIT LEVEL FOR 220 $V_{ac}$ OR 230 $V_{ac}$

↓

PERFORM OPERATION OF ELECTRICAL DEVICE — S705

# FIG. 8

INPUT OF 110 $V_{ac}$ IS DETERMINED AND DC LINK VOLTAGE IS IN OVERCHARGED STATE —— S801

↓

SET UNDERVOLTAGE PROTECTION LEVEL AND INPUT CURRENT LIMIT LEVEL BASED ON 110 $V_{ac}$ —— S802

↓

S803

DC LINK VOLTAGE < OVERVOLTAGE PROTECTION LEVEL? —— NO

YES ↓

SET OVERVOLTAGE PROTECTION LEVEL BASED ON 110 $V_{ac}$ —— S804

↓

COMPLETE PROTECTION LEVEL SETTING —— S805

# FIG. 9

# FIG. 10

$n_1 = \dfrac{dV_1}{dt_1}$

1001
DC LINK VOLTAGE

dV1

dt1

1002
INRUSH CURRENT

$n_2 = \dfrac{dV_2}{dt_2}$

1003
DC LINK VOLTAGE

dV2

dt2

1004
INRUSH CURRENT

# FIG. 11

FIRST VOLTAGE SENSOR VALUE RECEIVER /601

SECOND VOLTAGE SENSOR VALUE RECEIVER /602

/904

VOLTAGE RISING SLOPE DETECTOR /1101

VOLTAGE DETERMINER /603

RELAY CONTROLLER /1102

PROTECTION LEVEL SETTING UNIT /604

VOLTAGE COMMAND

SWITCH CONTROLLER

RELAY CONTROL SIGNAL

# FIG. 12

# FIG. 13

602

SECOND VOLTAGE
SENSOR VALUE
RECEIVER

1101

VOLTAGE
RISING SLOPE
DETECTOR

1102

RELAY
CONTROLLER

RELAY CONTROL SIGNAL

1201

## FIG. 14

EP 4 489 284 A1

# FIG. 15

START

DETECT INPUT VOLTAGE INFORMATION AND DC LINK VOLTAGE INFORMATION — S1510

OBTAIN INPUT VOLTAGE INFORMATION OF ELECTRICAL DEVICE — S1520

DETERMINE WHETHER INPUT VOLTAGE OF ELECTRICAL DEVICE IS LOW VOLTAGE OR HIGH VOLTAGE — S1530

SET PROTECTION LEVEL OF POWER FACTOR CORRECTION CIRCUIT ACCORDING TO DETERMINED INPUT VOLTAGE — S1540

CONTROL OPERATION OF POWER FACTOR CORRECTION CIRCUIT BASED ON SET PROTECTION LEVEL — S1550

END

# FIG. 16

```
                    ( START )
                        │
                        ▼
┌─────────────────────────────────────────┐
│  DETECT INPUT VOLTAGE INFORMATION AND    │──── S1610
│      DC LINK VOLTAGE INFORMATION         │
└─────────────────────────────────────────┘
                        │
                        ▼
┌─────────────────────────────────────────┐
│      OBTAIN INPUT VOLTAGE INFORMATION    │──── S1620
│          OF ELECTRICAL DEVICE            │
└─────────────────────────────────────────┘
                        │
                        ▼
┌─────────────────────────────────────────┐
│       DETERMINE WHETHER INPUT VOLTAGE    │
│   OF ELECTRICAL DEVICE IS LOW VOLTAGE    │──── S1630
│             OR HIGH VOLTAGE              │
└─────────────────────────────────────────┘
                        │
                        ▼
┌─────────────────────────────────────────┐
│  SET PROTECTION LEVEL OF POWER FACTOR    │
│    CORRECTION CIRCUIT ACCORDING TO       │──── S1640
│        DETERMINED INPUT VOLTAGE          │
└─────────────────────────────────────────┘
                        │
                        ▼
┌─────────────────────────────────────────┐
│   CONTROL OPERATION OF POWER FACTOR      │
│    CORRECTION CIRCUIT BASED ON SET       │──── S1650
│            PROTECTION LEVEL              │
└─────────────────────────────────────────┘
                        │
                        ▼
┌─────────────────────────────────────────┐
│  DETECT RISING SLOPE OF DC LINK VOLTAGE  │──── S1660
│     TO CONTROL OPERATION OF RELAY        │
└─────────────────────────────────────────┘
                        │
                        ▼
                     ( END )
```

FIG. 17

START

DETECT RISING SLOPE OF DC LINK VOLTAGE — S1710

COMPARE DETECTED SLOPE WITH
PRESET REFERENCE LEVEL — S1720

CONTROL OPERATION OF RELAY — S1730

END

## INTERNATIONAL SEARCH REPORT

International application No.

**PCT/KR2023/005080**

### A. CLASSIFICATION OF SUBJECT MATTER

**H02M 1/42**(2007.01)i; **H02M 1/32**(2007.01)i; **H02H 7/12**(2006.01)i; **H02H 3/44**(2006.01)i

According to International Patent Classification (IPC) or to both national classification and IPC

### B. FIELDS SEARCHED

Minimum documentation searched (classification system followed by classification symbols)

H02M 1/42(2007.01); G05F 1/70(2006.01); H02M 1/00(2007.01); H02M 3/28(2006.01); H02M 3/335(2006.01); H02M 7/12(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 역률 보상 회로(power factor correction circuit), 입력 전압(input voltage), 과전압 (over voltage), 저전압(low voltage), 입력 전류 제한(input current limit), 보호 레벨(protection level)

### C. DOCUMENTS CONSIDERED TO BE RELEVANT

| Category* | Citation of document, with indication, where appropriate, of the relevant passages | Relevant to claim No. |
|---|---|---|
| Y | JP 2005-057871 A (SONY CORP.) 03 March 2005 (2005-03-03)<br>See paragraphs [0003] and [0013]-[0031]; and figure 1. | 1-2,5-6,10,13 |
| A | | 3-4,7,11-12 |
| Y | KR 10-1251846 B1 (SAMSUNG ELECTRO-MECHANICS CO., LTD.) 09 April 2013 (2013-04-09)<br>See paragraphs [0021] and [0028]-[0029]; and figures 1-2. | 1-2,5-6,10,13 |
| A | KR 10-1397920 B1 (INJE UNIVERSITY INDUSTRY-ACADEMIC COOPERATION FOUNDATION) 30 May 2014 (2014-05-30)<br>See paragraphs [0019]-[0036]; and figures 1-6. | 1-7,10-13 |
| A | KR 10-1141673 B1 (OPEN DIGITAL POWER CO., LTD.) 04 May 2012 (2012-05-04)<br>See paragraphs [0013]-[0025]; and figures 4-6. | 1-7,10-13 |

☑ Further documents are listed in the continuation of Box C.     ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **26 July 2023** | **26 July 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/005080**

### C.    DOCUMENTS CONSIDERED TO BE RELEVANT

| Category* | Citation of document, with indication, where appropriate, of the relevant passages | Relevant to claim No. |
|---|---|---|
| A | US 10158282 B1 (FUJI ELECTRIC CO., LTD.) 18 December 2018 (2018-12-18)<br>See columns 4-12; and figures 1-4. | 1-7,10-13 |

Form PCT/ISA/210 (second sheet) (July 2022)

**INTERNATIONAL SEARCH REPORT**

International application No.

**PCT/KR2023/005080**

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
   because they relate to subject matter not required to be searched by this Authority, namely:

2. ☑ Claims Nos.: **15**
   because they relate to parts of the international application that do not comply with the prescribed requirements to such an extent that no meaningful international search can be carried out, specifically:

   Claim 15 refers to a claim violating PCT Rule 6.4(a). Therefore, claim 15 is unclear.

3. ☑ Claims Nos.: **8-9, 14**
   because they are dependent claims and are not drafted in accordance with the second and third sentences of Rule 6.4(a).

Form PCT/ISA/210 (continuation of first sheet) (July 2022)

**INTERNATIONAL SEARCH REPORT**
Information on patent family members

International application No.

**PCT/KR2023/005080**

| Patent document cited in search report | | | Publication date (day/month/year) | Patent family member(s) | | | Publication date (day/month/year) |
|---|---|---|---|---|---|---|---|
| JP | 2005-057871 | A | 03 March 2005 | None | | | |
| KR | 10-1251846 | B1 | 09 April 2013 | None | | | |
| KR | 10-1397920 | B1 | 30 May 2014 | KR 10-2013-0061870 | | A | 12 June 2013 |
| KR | 10-1141673 | B1 | 04 May 2012 | None | | | |
| US | 10158282 | B1 | 18 December 2018 | CN | 109088544 | A | 25 December 2018 |
| | | | | JP | 2019-004577 | A | 10 January 2019 |
| | | | | JP | 6904079 | B2 | 14 July 2021 |
| | | | | US | 2018-0367029 | A1 | 20 December 2018 |

Form PCT/ISA/210 (patent family annex) (July 2022)